# EUROPEAN PATENT APPLICATION

(11) **EP 4 836 645 A1**
(43) Date of publication of application: **04.11.2026**
(21) Application number: 24913816.5
(22) Date of filing: 16.12.2024
(51) Int. Cl.: H10H 29/01, H01L 25/075, H10H 20/819, H10H 20/812, H10H 20/841, H10H 20/855, H10H 20/00, H01L 23/00

(54) **DISPLAY DEVICE AND DISPLAY DEVICE MANUFACTURING METHOD**

(30) Priority: 27.12.2023 KR 20230192782
(71) Applicant: Samsung Display Co., Ltd., Yongin-si, Gyeonggi-do 17113 (KR)
(72) Inventor: KO, Hyo Jin, Yongin-si Gyeonggi-do 17113 (KR)
(74) Representative: Marks & Clerk LLP
(86) International application number: PCT/KR2024/097033
(87) International publication number: WO 2025/144012

(57) **Abstract**

A display device and a method for manufacturing the display device according to an embodiment are disclosed. A display device according to an embodiment includes a substrate, a light-emitting element above the substrate, and including a first semiconductor layer, an active layer, and a second semiconductor layer and a common electrode disposed on the light emitting element, wherein the second semiconductor layer has a lens-shaped upper surface disposed further away from the active layer, wherein side surfaces of the active layer and the second semiconductor layer are aligned.

## Description

### [Technical Field]

The present disclosure relates to a display device and a method for manufacturing the display device.

### [Background Art]

As the information society develops, the demand for display devices for displaying images is increasing in various forms. The display device may be a flat panel display device, such as a liquid crystal display, a field emission display, or a light-emitting display.

The light-emitting display device may be implemented as an organic light-emitting display device including an organic light-emitting diode element as a light-emitting element, an inorganic light-emitting display device including an inorganic semiconductor element as a light-emitting element, or a micro light-emitting diode display device including an ultra-small light-emitting diode element (or micro light-emitting diode element) as a light-emitting element. At this time, in the micro light-emitting diode display device, the micro light-emitting diode element is bonded to the pixel electrode, so it may be suitable to reduce the resistance of the pixel electrode.

### [Detailed Description of the Invention]

### [Technical Problem]

The problem to be solved by the present disclosure is to provide a light-emitting element integrated with a lens structure.

The tasks of the present invention are not limited to the tasks mentioned above, and other technical tasks not mentioned will be clearly understood by those skilled in the art from the description below.

### [Technical Solution]

A display device according to an embodiment for solving the above task includes a substrate, a pixel electrode disposed on the substrate, a light-emitting element above the pixel electrode, and including a first semiconductor layer, an active layer, and a second semiconductor layer having a lens-shaped upper surface that is further away from the active layer, and a common electrode above the light-emitting element, wherein side surfaces of the active layer and the second semiconductor layer are aligned.

In an embodiment, the second semiconductor layer may include a lens portion having a lens-shaped upper surface contacting the common electrode, and a body portion below a lower surface of the lens portion, wherein a side surface of the lens portion and a side surface of the body portion are aligned.

In an embodiment, the lens-shaped upper surface may be convex downward or convex upward.
In an embodiment, the display device may further include a connection electrode between the substrate and the light-emitting element, and having a diameter that is greater than a diameter of the light-emitting element.

In an embodiment, the diameter of the connection electrode may be greater than the diameter of the lens portion.

In an embodiment, the display device may further include an insulating layer partially surrounding the light-emitting element.

In an embodiment, the insulating layer may be on a side of the light-emitting element, and on a portion of the substrate on which the light-emitting element is not located.

In an embodiment, the display device may further include a reflective layer on the insulating layer and partially surrounding the light-emitting element.

In an embodiment, the display device may further include a connection electrode between the substrate and the light-emitting element, and having a diameter that is the same as the diameter of the light-emitting element and a diameter of the lens portion.

In an embodiment, the display device may further include a connection electrode between the substrate and the light-emitting element, and a pixel electrode between the substrate and the connection electrode.

In an embodiment, the display device may further include a convex lens-shaped micro lens above the common electrode, overlapping the light-emitting element, and convex downward.

In an embodiment, a lower surface of the micro lens may contact the common electrode.

In an embodiment, the second semiconductor layer may have multiple downwardly convex lens shapes.

A method of manufacturing a display device according to an embodiment for solving the above task includes stacking a first connection electrode layer on a second substrate on which a second semiconductor layer, an active layer, and a first semiconductor layer are sequentially grown, bonding the second substrate and a first substrate having a pixel circuit by melting the first connection electrode layer, removing the second substrate, forming a lens-shaped first mask pattern on an upper surface of the second semiconductor layer, etching the second semiconductor layer, the active layer, and the first semiconductor layer using the lens-shaped first mask pattern to form light-emitting elements having the second semiconductor layer with a lens-shaped upper surface, forming a second mask pattern surrounding the light-emitting elements, etching the first connection electrode layer using the second mask pattern, and forming a common electrode on the light-emitting elements, wherein side surfaces of the active layer and the second semiconductor layer are aligned.

In an embodiment, the lens-shaped upper surface may be convex downward or convex upward.

In an embodiment, the method may further include stacking a second connection electrode layer on a portion of the first substrate having the pixel circuit, and forming a connection electrode by melting and bonding the first connection electrode layer and the second connection electrode layer.

In an embodiment, the method may further include depositing an insulating layer on the light-emitting element and on a portion of a first substrate on which the light-emitting element is not located, forming a planarization layer on a portion of the first substrate on which the insulating layer is formed, the planarization layer being lower than a height of the light-emitting element, and removing a portion of the insulating layer from a portion of the light-emitting element that is not covered by the planarization layer.

In an embodiment, the method may further include depositing a reflective material layer on a portion of the first substrate on which the insulating layer is laminated, and removing a portion of the reflective material layer from a horizontal surface of the first substrate to form a reflective layer partially surrounding a side of the light-emitting element.

A method of manufacturing a display device according to an embodiment for solving the above task includes stacking a connection electrode layer on a second substrate on which a second semiconductor layer, an active layer, and a first semiconductor layer are located, forming light-emitting elements by etching the active layer, the first semiconductor layer, and the connection electrode layer, bonding the second substrate having the light-emitting elements on a carrier substrate, removing the second substrate, forming a lens-shaped mask pattern on an upper surface of the second semiconductor layer, etching the upper surface of the second semiconductor layer to have a lens shape using the lens-shaped mask pattern, wherein sides of the active layer and the second semiconductor layer are aligned, transferring the light-emitting elements on the carrier substrate onto a first substrate including a pixel electrode using an interposer substrate, removing the interposer substrate, and forming a common electrode on the light-emitting elements.

In an embodiment, the lens shape may be convex downward or convex upward.

In an embodiment, the carrier substrate may include a support layer that is transparent and mechanically stable, and an adhesive layer on the support layer.

In an embodiment, the interposer substrate may include a support layer that is transparent and mechanically stable, and an adhesive layer on the support layer.

In an embodiment, the method may further include depositing an insulating layer on the light-emitting element and on a portion of a first substrate on which the light-emitting element is not located, depositing a reflective material layer on a portion of the first substrate on which the insulating layer is laminated, forming a reflective layer surrounding a side of the light-emitting element by removing a portion of the reflective material layer above a horizontal surface of the first substrate, forming a planarization layer on the first substrate on which the insulating layer is formed, the planarization layer being lower than a height of the light-emitting element, and removing a portion of the insulating layer from the light-emitting element that is not covered by the planarization layer.

Other details of the embodiments are included in the detailed description and the drawings.

### [Effects of the Invention]

According to a display device according to embodiments, the amount of light emitted from the active layer may be improved by adjusting the divergence angle or viewing angle of light emitted from the active layer MQW.

Furthermore, it is not necessary to add a lens structure formed by a separate organic layer or the like, thereby simplifying the manufacturing process of the display device.

Additionally, collimation between the light-emitting element LE and a separate lens structure becomes unnecessary.

In addition, during the process, it is not necessary to consider the stability, refractive index, transmittance, etc. of the separately formed lens structure material.

The effects according to the embodiments are not limited to the contents exampled above, and more diverse effects are included in the present disclosure.

### [Brief Description of the Drawings]

FIG. 1 is a perspective view illustrating a display device according to one or more embodiments.
FIGS. 2 and 3 are plan views illustrating a display device according to one or more embodiments.
FIG. 4 is a circuit diagram illustrating a first sub-pixel of a display panel according to one or more embodiments.
FIG. 5 is a circuit diagram illustrating a first sub-pixel of a display panel according to one or more other embodiments.
FIG. 6 is a cross-sectional view schematically illustrating a display area of a display device according to one or more embodiments.
FIG. 7 is an enlarged view illustrating the common electrode and light-emitting element shown in FIG. 6 in detail.
FIG. 8 is a cross-sectional view schematically illustrating a display area of a display device according to one or more other embodiments.
FIG. 9 is an enlarged view illustrating the common electrode and light-emitting element shown in FIG. 8 in detail.
FIG. 10a is a cross-sectional view schematically illustrating a display area of a display device according to one or more other embodiments, and FIG. 10b is an enlarged view illustrating the common electrodes and light-emitting elements illustrated in FIG. 10a in detail.
FIGS. 11a and 11b are cross-sectional views schematically illustrating a display area of a display device according to one or more other embodiments.
FIG. 12 is a cross-sectional view schematically illustrating a display area of a display device according to one or more other embodiments.
FIG. 13 is an enlarged view illustrating the common electrode and light-emitting element shown in FIG. 12 in detail.
FIG. 14 is a cross-sectional view schematically illustrating a display area of a display device according to one or more other embodiments.
FIG. 15 is an enlarged view illustrating the common electrode and light-emitting element shown in FIG. 14 in detail.
FIG. 16 is a cross-sectional view schematically illustrating a display device including a wavelength conversion layer and a color filter layer according to one or more other embodiments.
FIG. 17 to 26 are cross-sectional views to illustrate a method of manufacturing a display device according to one or more embodiments.
FIGS. 27 to 30 are cross-sectional views to illustrate a method of manufacturing a display device according to one or more other embodiments.
FIGS. 31 to 43 are cross-sectional views to illustrate a method of manufacturing a display device according to one or more other embodiments.
FIG. 44 is a diagram schematically showing a virtual reality device including a display device according to one or more embodiments.
FIG. 45 is a diagram schematically showing a smart device including a display device according to one or more embodiments.
FIG. 46 is a diagram schematically showing a vehicle including a display device according to one or more embodiments.
FIG. 47 is a diagram schematically showing a transparent display device including a display device according to one or more embodiments.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Although terms such as "first," "second," etc., are used to describe various components, these components are not limited by these terms. These terms are merely used to distinguish one component from another. Therefore, the first component mentioned below may also be the second component within the technical concept of the present invention.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

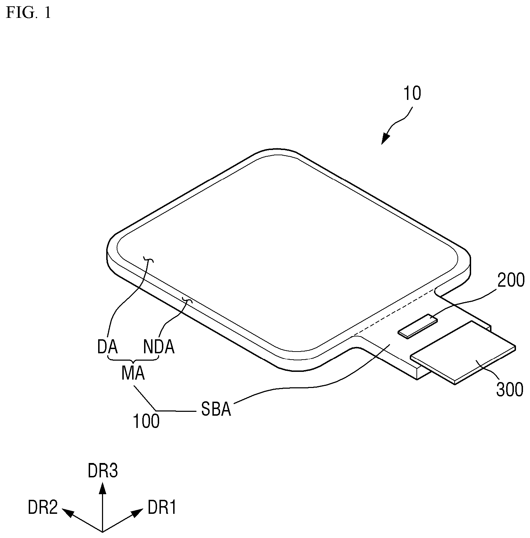

FIG. 1 is a perspective view illustrating a display device according to one or more embodiments.

Referring to FIG. 1, a display device 10 is a device for displaying video or still images, such as mobile phones, smart phones, tablet personal computers, and portable electronic devices, such as smart watches, watch phones, mobile communication terminals, electronic notebooks, e-books, portable electronic devices, such as portable multimedia players (PMP), navigation, and ultra-mobile PCs (UMPC), as well as display screens for a variety of products, such as televisions, laptops, monitors, billboards, and the internet of things (IOT) device.

The display device 10 may be a light-emitting display device, such as an organic light-emitting display device utilizing an organic light-emitting diode, a quantum dot light-emitting display device including a quantum dot light-emitting layer, an inorganic light-emitting display device including an inorganic semiconductor, and a miniaturized light-emitting display device utilizing a micro or nano light-emitting diode (micro LED or nano LED). Hereinafter, the description focuses on the fact that the display device 10 is a microlight-emitting display device, but the present disclosure is not limited thereto. On the other hand, the subminiature light-emitting diode is described herein as a micro light-emitting diode for convenience of explanation.

The display device 10 includes a display panel 100, a display-driving circuit 200, and a circuit board 300.

The display panel 100 may be formed as a rectangular-shaped plane having a short side in the first direction DR1, and a long side in the second direction DR2 that intersects the first direction DR1. A corner where the short side in the first direction DR1 and the long side in the second direction DR2 meet may be rounded to have a predetermined curvature or may be formed at a right angle. The planar shape of the display panel 100 is not limited to a rectangle, and may be formed in other polygonal, circular, or oval shapes. The display panel 100 may be formed flat but is not limited thereto. For example, the display panel 100 is formed at left and right ends, and may include curved portions with a constant curvature or a changing curvature. Additionally, the display panel 100 may be formed to be flexible, such as to be able to be bent, curved, bent, folded, or rolled.

The substrate SUB of the display panel 100 may include a main area MA and a sub-area SBA.

The main area MA may include a display area DA that displays an image, and a non-display area NDA that is a peripheral area of the display area DA. The display area DA may include a plurality of pixels that display an image. For example, the pixel may include a first sub-pixel that emits first light, a second sub-pixel that emits second light, and a third sub-pixel that emits third light.

The sub-area SBA may protrude from one side of the main area MA in the second direction DR2. Although FIG. 1 illustrates the sub-area SBA being unfolded, the sub-area SBA may be bent, and in this case, may be located on the bottom surface of the display panel 100. When the sub-area SBA is bent, it may overlap the main area MA in the third direction DR3, which is the thickness direction of the display panel 100. The display-driving circuit 200 may be located in the sub-area SBA.

The display-driving circuit 200 may generate signals and voltages for driving the display panel 100. The display-driving circuit 200 may be formed as an integrated circuit (IC), and may be attached to the display panel 100 using a chip-on-glass (COG) method, a chip-on-plastic (COP) method, or an ultrasonic bonding method but is not limited thereto. For example, the display-driving circuit 200 may be attached to the circuit board 300 using a chip-on-film (COF) method.

The circuit board 300 may be attached to one end of the sub-area SBA of the display panel 100. As such, the circuit board 300 may be electrically connected to the display panel 100 and the display-driving circuit 200. The display panel 100 and the display-driving circuit 200 may receive digital video data, timing signals, and driving voltages through the circuit board 300. The circuit board 300 may be a flexible film, such as a flexible printed circuit board, a printed circuit board, or a chip on film.

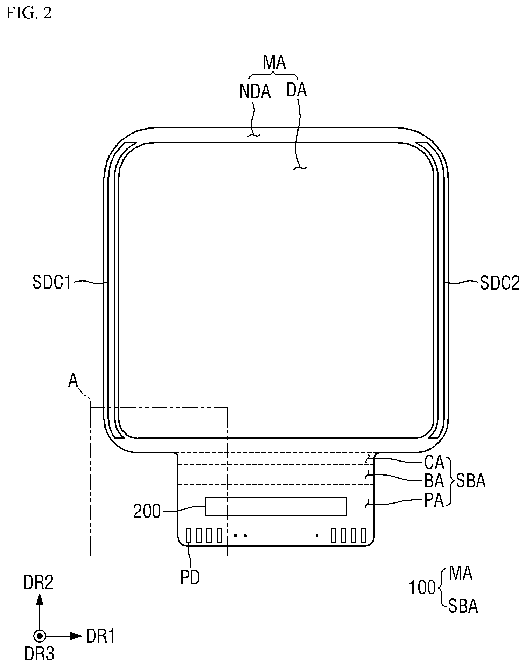

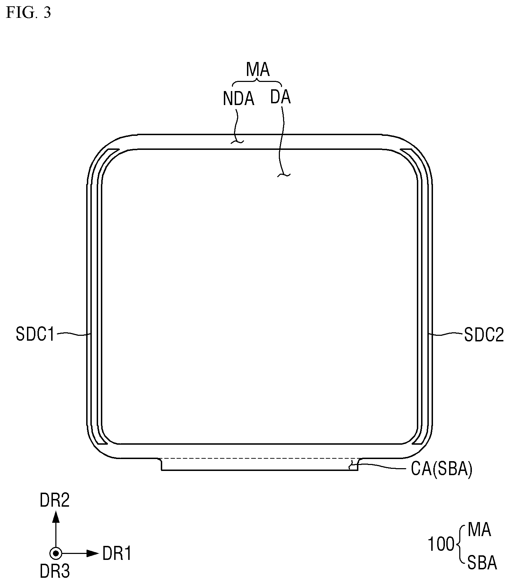

FIGS. 2 and 3 are plan views illustrating a display device according to one embodiment. FIG. 2 illustrates that the sub-area SBA is unfolded without being bent. FIG. 3 illustrates that the sub-area SBA is bent.

Referring to FIGS. 2 and 3, the display panel 100 may include the main area MA and the sub-area SBA.

The main area MA may include the display area DA that displays an image, and the non-display area NDA that is a peripheral area of the display area DA. The display area DA may occupy most of the main area MA. The display area DA may be placed in the center of the main area MA.

The non-display area NDA may be placed adjacent to the display area DA. The non-display area NDA may be an area outside the display area DA. The non-display area NDA may be arranged to surround the display area DA. The non-display area NDA may be an edge area of the display panel 100.

A first scan-driving portion SDC1 and a second scan-driving portion SDC2 may be located in the non-display area NDA. The first scan-driving portion SDC1 is located on one side (for example, the left side) of the display panel 100, and the second scan-driving portion SDC2 is located on the other side (for example, the right side) of the display panel 100. However, the present disclosure is not limited to this. Each of the first scan-driving portion SDC1 and the second scan-driving portion SDC2 may be electrically connected to the display-driving circuit 200 through scan fan-out lines. Each of the first scan-driving portion SDC1 and the second scan-driving portion SDC2 may receive a scan control signal from the display-driving circuit 200, may generate scan signals according to the scan control signal, and may output them to the scan lines.

The sub-area SBA may protrude from one side of the main area MA in the second direction DR2. The length of the sub-area SBA in the second direction DR2 may be less than the length of the main area MA in the second direction DR2. The length of the first direction DR1 of the sub-area SBA is less than the length of the first direction DR1 of the main area MA, or may be substantially equal to the length of the first direction DR1 of the main area MA. The sub-area SBA may be curved, and may be located at the lower portion of the display panel 100. In this case, the sub-area SBA may overlap the main area MA in the third direction DR3.

The sub-area SBA may include a connection area CA, a pad area PA, and a bending area BA.

The connection area CA is an area protruding from one side of the main area MA in the second direction DR2. One side of the connection area CA may contact the non-display area NDA of the main area MA, and the other side of the connection area CA may contact the bending area BA.

The pad area PA is an area where the pads PD and the display-driving circuit 200 are arranged. The display-driving circuit 200 may be attached to the driving pads of the pad area PA using a conductive adhesive member, such as an anisotropic conductive film. The circuit board 300 may be attached to the pads PD of the pad area PA using a conductive adhesive member, such as an anisotropic conductive film. One side of the pad area PA may contact the bending area BA.

The bending area BA is a bent area. When the bending area BA is bent, the pad area PA may be located below the connection area CA and below the main area MA. The bending area BA may be located between the connection area CA and the pad area PA. One side of the bending area BA may contact the connection area CA, and the other side of the bending area BA may contact the pad area PA.

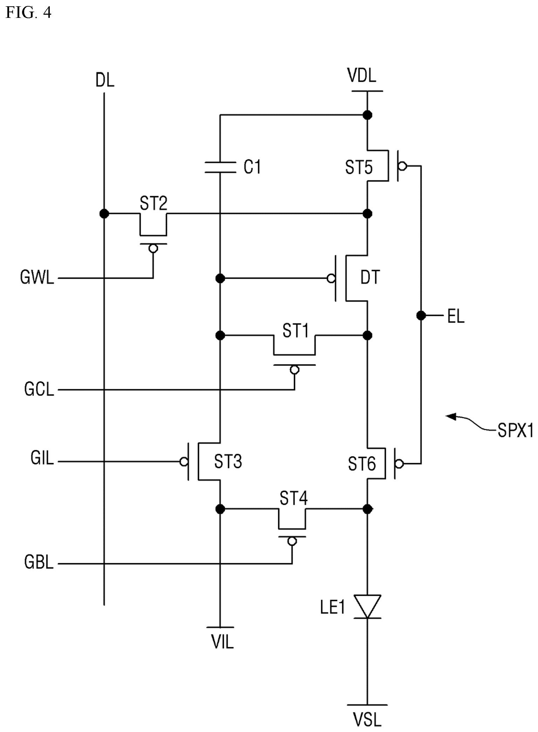

FIG. 4 is a circuit diagram illustrating a first sub-pixel of a display panel according to one embodiment.

Referring to FIG. 4, the first sub-pixel SPX1 according to one embodiment may be connected to scan lines GWL, GIL, GCL, and GBL, light-emitting lines EL, and data lines DL. For example, the first sub-pixel SPX1 may be connected to a write scan line GWL, an initialization scan line GIL, the control scan line GCL, the bias scan line GBL, a light-emitting line EL, and the data line DL.

The first sub-pixel SPX1 according to one or more embodiments includes a driving transistor DT, switch elements, a capacitor C1, and a first light-emitting element LE1. The switch elements include first to sixth transistors ST1, ST2, ST3, ST4, ST5, and ST6.

The driving transistor DT includes a gate electrode, a first electrode, and a second electrode. The driving transistor DT controls the drain-source current (hereinafter referred to as "driving current") flowing between the first electrode and the second electrode according to the data voltage applied to the gate electrode.

The first light-emitting element LE1 emits light according to the driving current. The amount of light emitted from the first light-emitting element LE1 may be proportional to the driving current Ids. An anode electrode of the first light-emitting element LE1 may be connected to the first electrode of the fourth transistor ST4 and the second electrode of the sixth transistor ST6, and a cathode electrode may be connected to the second power supply line VSL to which the second power supply voltage is applied.

The capacitor C1 is formed between the second electrode of the driving transistor DT and the first power supply line VDL to which the first power supply voltage is applied. The first power supply voltage may be at a higher level than the second power supply voltage. One electrode of the capacitor C1 may be connected to the second electrode of the driving transistor DT, and the other electrode may be connected to the first power supply line VDL.

As shown in FIG. 4, the first to sixth transistors ST1, ST2, ST3, ST4, ST5, and ST6 and the driving transistor DT may all be formed as p-type MOSFET. In this case, the active layer of each of the first to sixth transistors ST1, ST2, ST3, ST4, ST5, and ST6 and the driving transistor DT may be formed of polysilicon or oxide semiconductor.

The gate electrode of the second transistor ST2 may be connected to the write scan line GWL, and the gate electrode of the first transistor ST1 may be connected to the control scan line GCL. The gate electrode of the third transistor ST3 may be connected to the initialization scan line GIL, and the gate electrode of the fourth transistor ST4 may be connected to the bias scan line GBL. Because the first to sixth transistors ST1, ST2, ST3, ST4, ST5, and ST6 are formed as p-type MOSFET, they may be turned on when a scan signal of the gate low voltage and an emission signal are applied to the control scan line GCL, the initialization scan line GIL, the write scan line GWL, the bias scan line GBL, and the light-emitting line EL, respectively. One electrode of the third transistor ST3 and one electrode of the fourth transistor ST4 may be connected to an initialization voltage line VIL.

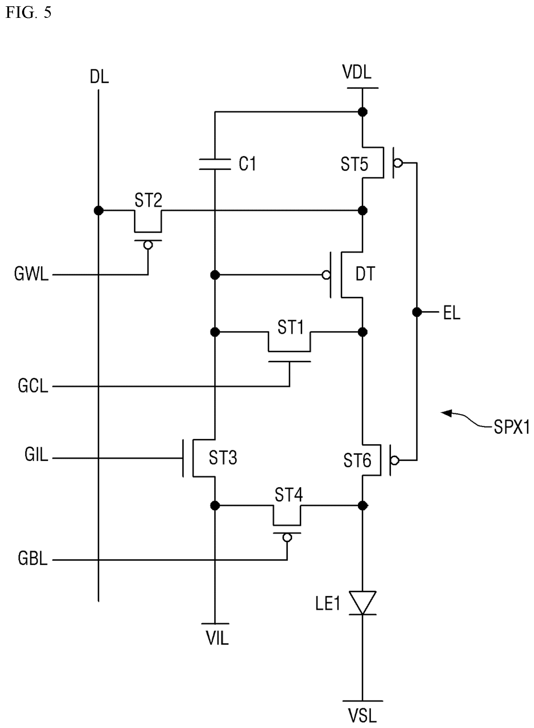

FIG. 5 is a circuit diagram illustrating a first sub-pixel of a display panel according to another embodiment.

Referring to FIG. 5, the driving transistor DT, the second transistor ST2, the fourth transistor ST4, the fifth transistor ST5, and the sixth transistor ST6 are formed of p-type MOSFET, and the first transistor ST1 and the third transistor ST3 may be formed as n-type MOSFET. The active layer of each of the driving transistor DT, the second transistor ST2, the fourth transistor ST4, the fifth transistor ST5, and the sixth transistor ST6 formed as the p-type MOSFET may be formed of polysilicon, and the active layer of each of the first transistor ST1 and the third transistor ST3 formed as the n-type MOSFET may be formed of the oxide semiconductor. In this case, transistors formed of polysilicon and transistors formed of oxide semiconductors may be arranged in different layers.

Because the first transistor ST1 and the third transistor ST3 are formed as n-type MOSFET, the first transistor ST1 may be turned on when a control scan signal with a gate high voltage is applied to the control scan line GCL, and the third transistor ST3 may be turned on when an initialization scan signal is applied to the initialization scan line GIL. In comparison, the second transistor ST2, the fourth transistor ST4, the fifth transistor ST5, and the sixth transistor ST6 are formed as p-type MOSFET, so they may be turned on when a scan signal with a gate low voltage and an emission signal are applied to the write scan line GWL, the bias scan line GBL, and the light-emitting line EL, respectively.

Alternatively, the fourth transistor ST4 in FIG. 4 may be formed of the n-type MOSFET. In this case, the active layer of each fourth transistor ST4 may be formed of the oxide semiconductor. When the fourth transistor ST4 is formed of n-type MOSFET, it may be turned on when a bias scan signal of a gate high voltage is applied to the bias scan line GBL.

Alternatively, although not shown in FIGS. 4 and 5, the first to sixth transistors ST1, ST2, ST3, ST4, ST5, and ST6 and the driving transistor DT may all be formed as n-type MOSFET.

Meanwhile, the circuit diagram of the second sub-pixel and the third sub-pixel according to one embodiment are substantially the same as the circuit diagram of the first sub-pixel SPX1 described in conjunction with FIGS. 4 and 5, so a description thereof will be omitted.

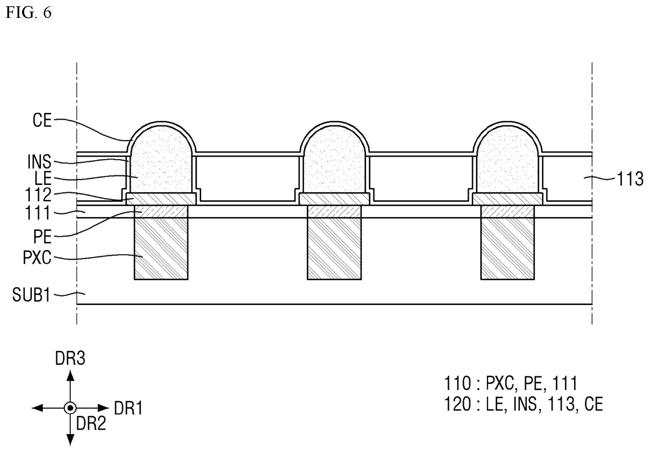

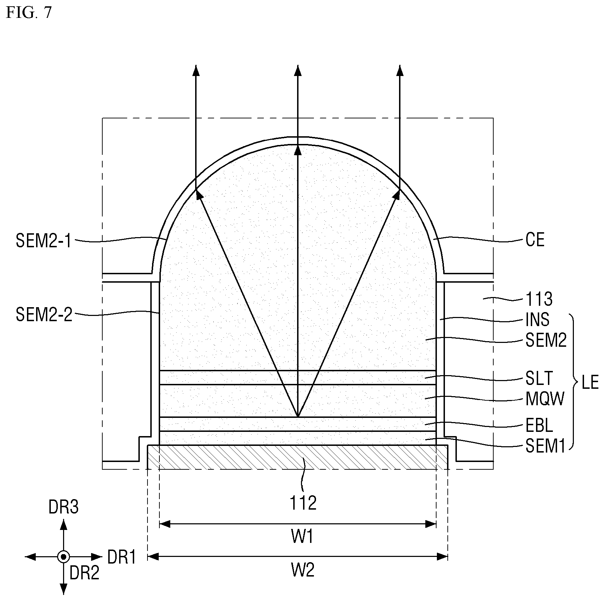

FIG. 6 is a cross-sectional view schematically illustrating a display area of a display device according to one embodiment. FIG. 7 is an enlarged view illustrating the common electrode and light-emitting element shown in FIG. 6 in detail.

Referring to FIGS. 6 and 7, the display panel 100 may include a semiconductor circuit board 110 and a light-emitting element layer 120.

The semiconductor circuit board 110 may include a plurality of pixel circuit portions PXC and a pixel electrode PE.

The first substrate SUB1 may be a silicon wafer substrate. The first substrate SUB1 may be made of single crystal silicon.

Each of the plurality of pixel circuit portions PXC may be located on the first substrate SUB1. Each of the plurality of pixel circuit portions PXC may include a complementary metal-oxide semiconductor (CMOS) circuit formed using a semiconductor process. Each of the plurality of pixel circuit portions PXC may include at least one transistor formed through a semiconductor process. Additionally, each of the plurality of pixel circuit portions PXC may further include at least one capacitor formed through a semiconductor process.

The plurality of pixel circuit portions PXC may be located in the display area DA. Each of the plurality of pixel circuit portions PXC may be connected to the corresponding pixel electrode PE. Each of the plurality of pixel circuit portions PXC may apply a pixel voltage or an anode voltage to the pixel electrode PE.

Each of the pixel electrodes PE may be located on the corresponding pixel circuit portion PXC. Each of the pixel electrodes PE may be an exposed electrode exposed from the pixel circuit portion PXC. That is, each of the pixel electrodes PE may protrude from the top surface of the pixel circuit portion PXC. Each of the pixel electrodes PE may be formed integrally with the pixel circuit portion PXC. Each of the pixel electrodes PE may receive a pixel voltage or an anode voltage from the pixel circuit portion PXC. The pixel electrodes PE may include copper (Cu), titanium (Ti), silver (Ag), magnesium (Mg), aluminium (Al), platinum (Pt), lead (Pd), gold (Au), nickel (Ni), neodymium (Nd), iridium (Ir), chromium (Cr), lithium (Li), calcium (Ca), or mixtures thereof. Additionally, the pixel electrodes PE may have a multilayer structure in which two or more metal layers are stacked. For example, the pixel electrodes PE may have a two-layer structure in which a copper layer is stacked on a titanium layer but is not limited to this.

An interlayer insulating layer 111 may be located on the first substrate SUB1 on which the pixel electrodes PE are not located. The interlayer insulating layer 111 is located between the pixel electrodes PE, and the interlayer insulating layer 111 may be formed in a multi-stage structure.

The interlayer insulating layer 111 may be formed of an inorganic film, such as silicon oxide (SiO₂), aluminium oxide (Al₂O₃), or hafnium oxide (HfOₓ).

A connection electrode 112 may be located on the pixel electrode PE. The connection electrodes 112 may serve as a bonding metal for bonding the pixel electrodes PE and the light-emitting elements LE during the manufacturing process. The connection electrode 112 may serve to apply a light-emitting signal to the light-emitting element LE by bonding to the pixel electrode PE. The light-emitting element LE may include at least one connection electrode 112.

The connection electrode 112 may reduce the resistance between the light-emitting element LE and the contact electrode when the light-emitting element LE is electrically connected to the pixel electrode in the display panel 100, according to one or more embodiments. The connection electrode 112 may include a conductive metal. For example, the connection electrode 112 may include at least one of gold (Au), copper (Cu), tin (Sn), titanium (Ti), aluminium (Al), or silver (Ag). For example, the connection electrode 112 may include a 9:1 alloy of gold and tin, an 8:2 alloy, or a 7:3 alloy, or may comprise an alloy of copper, silver, and tin (SAC305).

Although not shown, an ohmic contact layer may be further located on the connection electrode 112. The ohmic contact layer may be located between the connection electrode 112 and the first semiconductor layer SEM1. The ohmic contact layer may be an ohmic connection electrode. However, the electrode is not limited to this and may be a Schottky connection electrode. The ohmic contact layer may include ITO. However, it is not limited to this, and may include at least one selected from gold (Au), copper (Cu), tin (Sn), titanium (Ti), aluminium (Al), or silver (Ag), and may be formed from an alloy thereof or a multilayer structure thereof.

The connection electrode 112 may have a diameter W2 that is greater than the diameter W1 of the light-emitting element LE. For example, the connection electrode 112 may protrude outside the light-emitting element LE located on the connection electrode 112.

The light-emitting element layer 120 may include a light-emitting element LE, an insulating layer INS, a planarization layer 113, and a common electrode CE.

Each of the light-emitting elements LE may be located on the connection electrode 112. The light-emitting element LE may overlap the pixel electrode PE.

The light-emitting element LE may be a vertical light-emitting diode element extending in the third direction DR3. That is, a length of the light-emitting element LE in the third direction DR3 may be longer than a length in the horizontal direction. The length in the horizontal direction indicates the length in the first direction DR1 or the length in the second direction DR2. For example, the length of the light-emitting element LE in the third direction DR3 may be about 1 *µ*m to about 5 *µ*m. The light-emitting element LE may have a top surface formed in a lens shape. The lens shape may be convex upward.

Referring to FIG. 7, the light-emitting element LE may be a micro light-emitting diode element or a nano light-emitting diode. The light-emitting element LE includes a first semiconductor layer SEM1, an electron-blocking layer EBL, an active layer MQW, a superlattice layer SLT, and a second semiconductor layer SEM2 in the third direction DR3. The first semiconductor layer SEM1, the electron-blocking layer EBL, the active layer MQW, the superlattice layer SLT, and the second semiconductor layer SEM2 may be sequentially stacked in the third direction DR3. Side surfaces of the first semiconductor layer SEM1, the electron-blocking layer EBL, the active layer MQW, the superlattice layer SLT, and the second semiconductor layer SEM2 may be located on the same line.

The light-emitting element LE may have a cylindrical shape, a disk shape, or a rod shape where the width is longer than the height. However, the present disclosure is not limited to this, and the light-emitting element LE may have the shape, such as a rod, wire, tube, or the like, or a polygonal shape, such as a cube, rectangular cube, hexagonal column, or the like.

The first semiconductor layer SEM1 may be located on the connection electrode 112. The first semiconductor layer SEM1 may be doped with a first conductivity type dopant, such as Mg, Zn, Ca, Se, or Ba. For example, the first semiconductor layer SEM1 may be p-GaN doped with p-type Mg. The thickness of the first semiconductor layer SEM1 may be about 30 nm to about 200 nm.

The electron-blocking layer EBL may be located on the first semiconductor layer SEM1. The electron-blocking layer EBL may be a layer to suppress or prevent too many electrons from flowing into the active layer MQW. For example, the electron-blocking layer EBL may be p-AlGaN doped with p-type Mg. The thickness of the electron-blocking layer EBL may be about 10 nm to about 50 nm. The electronic blocking layer EBL may be omitted.

The active layer MQW may be located on the electron-blocking layer EBL. The active layer MQW may emit light by combining electron-hole pairs according to electrical signals applied through the first semiconductor layer SEM1 and the second semiconductor layer SEM2. The active layer MQW may emit first light having a central wavelength range of about 450 nm to about 495 nm, that is, light in a blue wavelength band but is not limited thereto.

The active layer MQW may include a single or multiple quantum well structure. If the active layer MQW includes a material with a multi-quantum well structure, it may be a stacked structure with a plurality of well layers and a barrier layer alternating with each other. In this case, the well layer may be formed of InGaN and the barrier layer may be formed of GaN or AlGaN, but is not limited thereto. The thickness of the well layer may be about 1 nm to about 4 nm, and the thickness of the barrier layer may be about 3 nm to about 10 nm.

Alternatively, the active layer MQW may have a structure in which a semiconductor material having a large band gap energy and a semiconductor material having a small band gap energy are alternately stacked with each other and may include other Group 3 to Group 5 semiconductor materials depending on the wavelength band of the emitted light. The light emitted by the active layer MQW is not limited to first light (light in the blue wavelength band) but may in some cases emit second light (light in the green wavelength band) or third light (light in the red wavelength band).

The superlattice layer SLT may be located on the active layer MQW. The superlattice layer SLT may be a layer for relieving stress between the second semiconductor layer SEM2 and the active layer MQW. For example, the superlattice layer SLT may be formed of InGaN or GaN. The thickness of the superlattice layer SLT may be about 50 nm to about 200 nm. The superlattice layer SLT may be omitted.

The second semiconductor layer SEM2 may be located on the superlattice layer SLT. The second semiconductor layer SEM2 may be doped with a second conductivity type dopant, such as Si, Ge, Sn, or the like. For example, the second semiconductor layer SEM2 may be n-GaN doped with n-type Si. The thickness of the second semiconductor layer SEM2 may be about 500 nm to about 1 *µ*m.

The top surface of the second semiconductor layer SEM2 may have a lens shape. For example, the lens shape may be convex upward. The top surface of the second semiconductor layer SEM2 may contact the common electrode CE.

For convenience of explanation, the lens-shaped top surface of the second semiconductor layer SEM2 may be referred to as a lens portion SEM2-1, and the lower surface supporting the lens-shaped top surface may be referred to as a body portion SEM2-2. The diameter of the lens portion SEM2-1 may be the same as the diameter of the body portion SEM2-2. The lens portion SEM2-1 and the body portion SEM2-2 may be arranged in a row in the third direction but are not limited to this. Further, the material of the lens portion SEM2-1 may be the same as the material of the body portion SEM2-2.

The second semiconductor layer SEM2 has a lens-shaped top surface, thereby reducing the divergence angle or viewing angle of light emitted from the active layer MQW.

Because the top surface of the second semiconductor layer SEM2 is formed in a lens shape, a lens structure formed of a separate organic layer, or the like is not required. This simplifies the manufacturing process of the display device. Therefore, forming the top surface of the second semiconductor layer SEM2 into a lens shape is advantageous in terms of process time and cost compared to forming a separate lens structure.

Additionally, because the second semiconductor layer SEM2 has a lens-shaped top surface, collimation between the light-emitting element LE and a separate lens structure becomes unnecessary.

In addition, forming the top surface of the second semiconductor layer SEM2 into a lens shape does not need to consider the stability, refractive index, transmittance, etc. of a separately formed lens structure material.

Referring again to FIGS. 6 and 7, the insulating layer INS may be located on a side of each of the light-emitting elements LE and the connection electrode 112 that does not overlap the light-emitting elements LE, and on a portion of a top surface of the connection electrode 112. Further, the insulating layer INS may be located on the interlayer insulating layer 111 on which the light-emitting elements LE are not located.

Additionally, the insulating layer INS may be formed of an inorganic film, such as a silicon oxide film (SiO₂), an aluminium oxide film (Al₂O₃), or a hafnium oxide film (HfOₓ) but is not limited thereto.

The planarization layer 113 may be located on each side of the light-emitting elements LE. The planarization layer 113 may be a layer for flattening steps caused by the light-emitting elements LE. The top surfaces of the light-emitting elements LE and the top surface of the planarization layer 113 may be flat. The planarization layer 113 may be formed of an organic film, such as an acrylic resin, an epoxy resin, a phenolic resin, a polyamide resin, a polyimide resin, or the like.

Because the common electrode CE is located entirely on the first substrate SUB1 and applies a common voltage, it may include a material with low resistance. The common electrode CE may be located on the top surface of each of the light-emitting elements LE and the top surface of the planarization layer 113. The common electrode CE may directly contact the lens-shaped second semiconductor layer SEM2.

Further, the common electrode CE may be formed to be thin to facilitate light transmission. The common electrode CE may include a transparent conductive material. For example, the common electrode CE may include a transparent conductive oxide (TCO), such as indium tin oxide (ITO) or indium zinc oxide (IZO). The thickness of the common electrode CE may be about 10Å to about 200Å, but is not limited thereto.

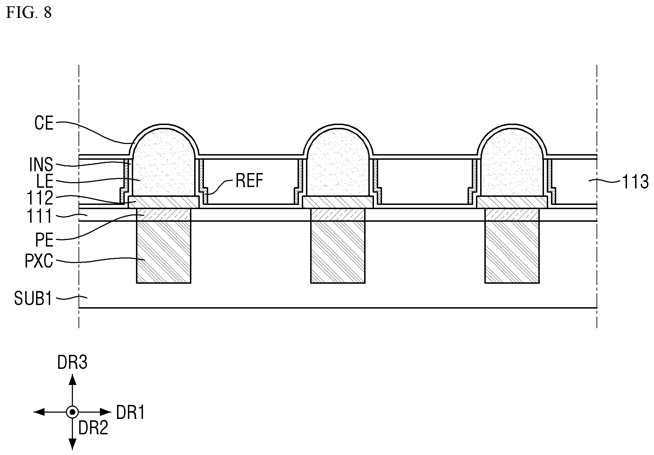

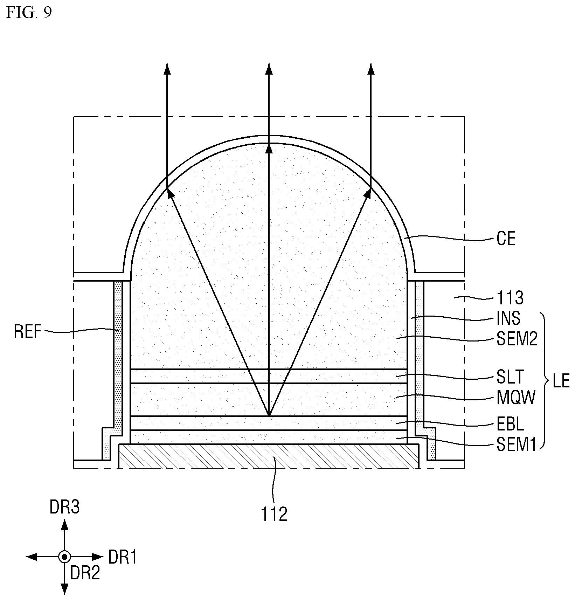

FIG. 8 is a cross-sectional view schematically illustrating a display area of a display device according to one or more other embodiments. FIG. 9 is an enlarged view illustrating the common electrode and light-emitting element shown in FIG. 8 in detail.

FIGS. 8 and 9 are different from the embodiments of FIGS. 6 and 7 in that the light-emitting element LE further includes a reflective layer REF. Hereinafter, the description referring to FIGS. 8 and 9 will focus on differences from the embodiments of FIGS. 6 and 7.

The reflective layer REF may be located on the insulating layer INS on each side of the light-emitting elements LE, on/above the top surface of the connection electrodes 112 that do not overlap the light-emitting element LE, and on the side of the connection electrode 112.

The reflective layer REF serves to reflect light emitted from the light-emitting element LE that travels in the down, left, and side directions rather than in the upward direction. The reflective layer REF may include a highly reflective metal material, such as aluminium (Al). The thickness of the reflective layer REF may be approximately 0.1 µm but is not limited thereto.

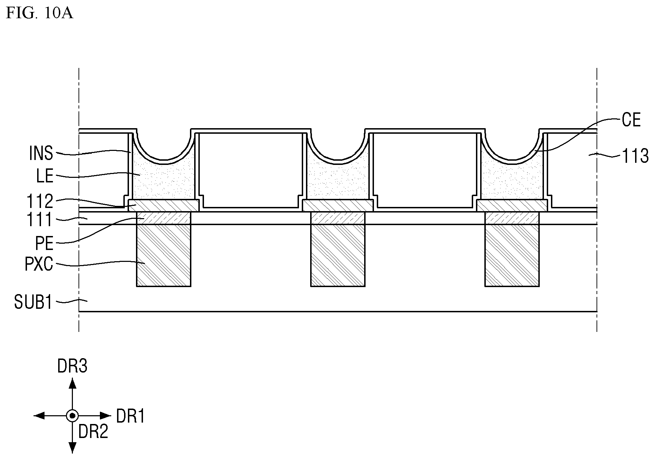

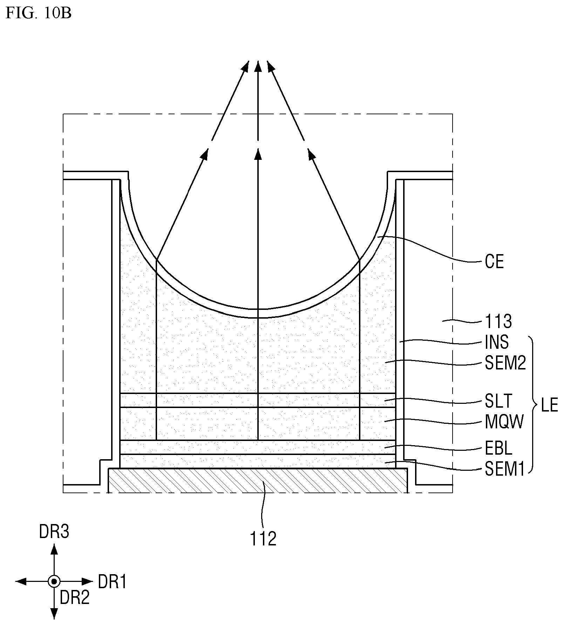

FIG. 10a is a cross-sectional view schematically illustrating a display area of a display device according to another embodiment, and FIG. 10b is an enlarged view illustrating the common electrodes and light-emitting elements illustrated in FIG. 10a in detail.

FIGS. 10a and 10b are different from the embodiments of FIGS. 6 and 7 in that the lens shape of the top surface of the light-emitting element LE is convex downward. Hereinafter, the description referring to FIGS. 10a and 10b will focus on differences from the embodiments of FIGS. 6 and 7.

Referring to FIGS. 10a and 10b, the top surface of the light-emitting element LE may be lens-shaped. The top surface of the light-emitting element LE has a convex shape toward the first substrate SUB1. The first common electrode CE has a convex shape that is convex downwardly along the top surface of the light-emitting element LE.

The light-emitting element LE may include a first semiconductor layer SEM1, an electron-blocking layer EBL, an active layer MQW, a superlattice layer SLT, and a second semiconductor layer SEM2.

The second semiconductor layer SEM2 may have a downwardly convex lens-shaped top surface, thereby concentrating light emitted from the active layer MQW and improving the front light emission effect. In another variant, a reflective layer may be located on the side of each of the light-emitting elements LE on the insulating layer INS, on the top surface of the connection electrodes 112 that do not overlap the light-emitting element LE, and on the side of the connection electrode 112. As described with reference to FIG. 9, the reflective layer may reflect light emitted from the light-emitting element LE that travels in the down, left, and side directions rather than in the upward direction.

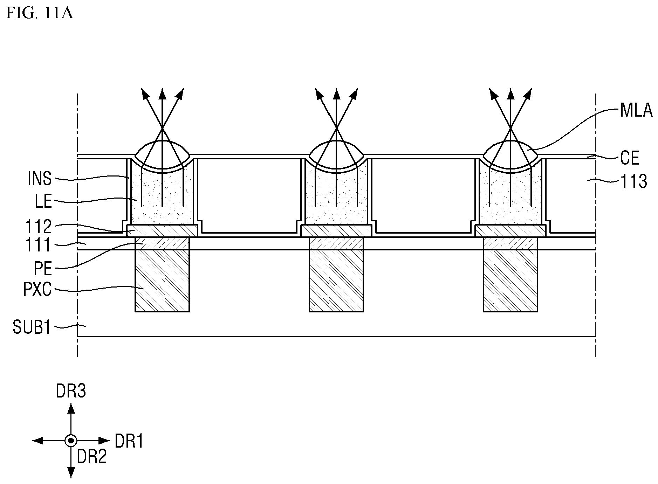

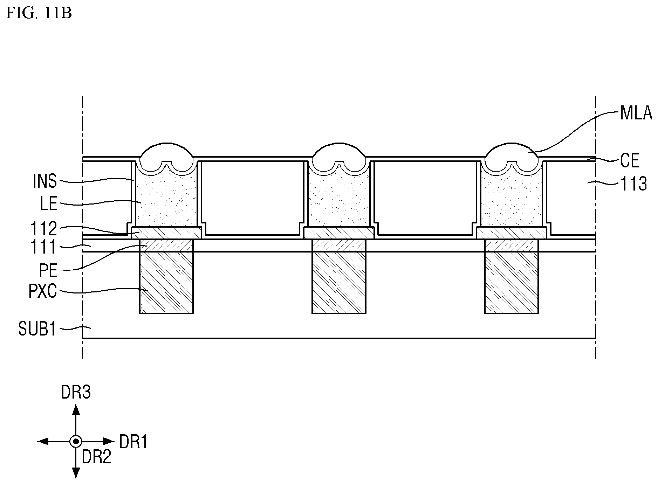

FIGS. 11a and 11b are cross-sectional views schematically illustrating a display area of a display device according to another embodiment.

FIG. 11a is different from the embodiment of FIGS. 10a and 10b in that a micro lens MLA is located on the top surface of the light-emitting element LE.

Hereinafter, the description referring to FIG. 11a will focus on differences from the embodiments of FIGS. 10a and 10b.

The top surface of the light-emitting element LE in FIG. 11A may be lens-shaped. The top surface of the light-emitting element LE has a convex shape toward the first substrate SUB1. The first common electrode CE has a convex shape that is convex downwardly along the top surface of the light-emitting element LE. The micro lens MLA may be located on the first common electrode CE. The micro lens MLA may have a curvature corresponding to the curvature of the first common electrode CE. The curvature of the micro lens MLA may be the same as the curvature of the first common electrode CE. The micro lens MLA may directly contact the common electrode CE on the first common electrode CE. By adjusting the curvature radius and height of each micro lens MLA, the focus of each micro lens MLA may be focused on the corresponding pixel PX.

The micro lens MLA may be formed to fill the concave groove of the first common electrode CE on the top surface of the light-emitting element LE, and may protrude convexly upward. The micro lens MLA may have a convex lens shape that protrudes convexly on the top surface of the light-emitting element LE.

The micro lens MLA may include organic or inorganic materials, such as polydimethylsiloxane (PDMS), polymethyl methacrylate (PMMA), photoresist, silicon dioxide (SiO₂), or the like.

FIG. 11b is different from FIG. 11a in that a curve is formed on the top surface of the light-emitting element LE.

In FIG. 11b, it is exemplified that two concave lens shapes are formed on the top surface of the light-emitting element LE but is not limited to this, and a plurality of downwardly convex lens shapes may be formed on the top surface of the light-emitting element LE. Each of the plurality of convex lens shapes has a curvature, and the curvature of each of the plurality of convex lens shapes may be the same, but is not limited thereto, and lens shapes having different curvatures may be formed. For example, when there are three plurality of downwardly convex lens shapes, the curvature of the lens shape located in the center may be the largest, and the curvature of the lens shapes located on both sides may be relatively small.

Along with the downward convex lens shape on the top surface of the light-emitting element LE, the common electrode CE may also have a downward concave lens shape on the light-emitting element LE. Furthermore, the micro lens MLA may be formed to fill the concave groove on the common electrode CE overlapping the top surface of the light-emitting element LE, and may protrude convexly upward.

As shown in FIGS. 11a and 11b, adding a separate micro lens MLA to the top surface of the light-emitting element LE may have the effect of controlling the direction of light emission.

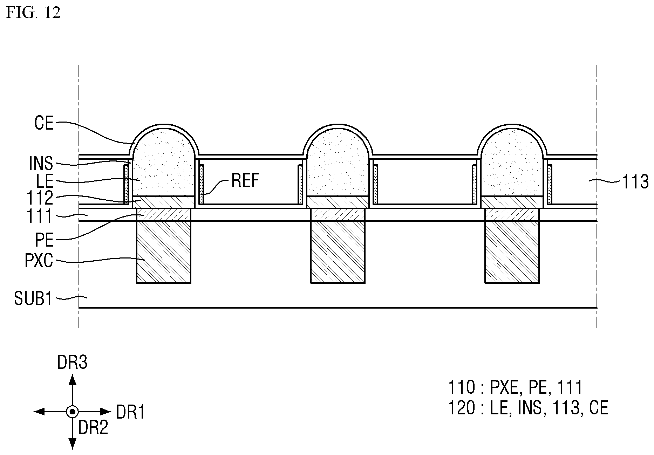

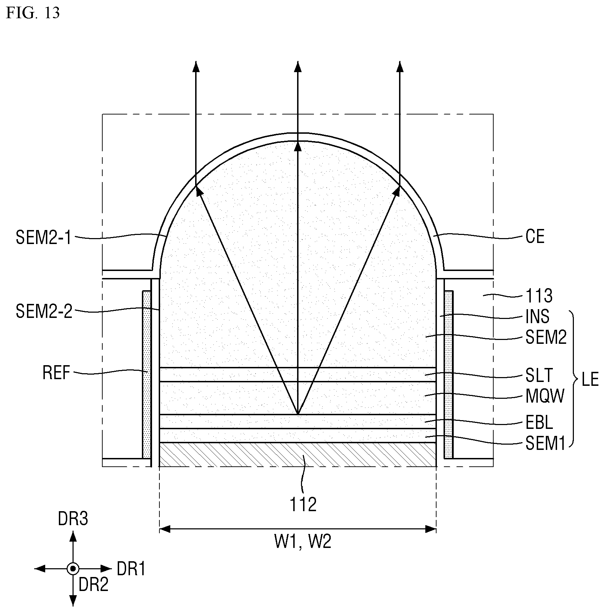

FIGS. 12 and 13 are different from the embodiments of FIGS. 8 and 9 in that the diameter of the connection electrode 112 and the diameter of the light-emitting element LE are the same. Hereinafter, the description referring to FIGS. 12 and 13 will focus on differences from the embodiments of FIGS. 8 and 9.

Referring to FIGS. 12 and 13, the diameter of the light-emitting element LE and the diameter of the connection electrode 112 may be the same. The light-emitting element LE and the connection electrode 112 may completely overlap in the third direction DR3.

The light-emitting element LE may include a first semiconductor layer SEM1, an electron-blocking layer EBL, an active layer MQW, a superlattice layer SLT, and a second semiconductor layer SEM2.

The sides of the first semiconductor layer SEM1, the electron-blocking layer EBL, the active layer MQW, the superlattice layer SLT, the second semiconductor layer SEM2, and the connection electrode 112 may be located on the same line.

The sides of the first semiconductor layer SEM1, the electron-blocking layer EBL, the active layer MQW, the superlattice layer SLT, the second semiconductor layer SEM2, and the connection electrode 112 may be arranged in a line in the third direction.

The second semiconductor layer SEM2 may include a lens portion SEM2-1 and a body portion SEM2-2. The diameter of the lens portion SEM2-1 may be the same as the diameter of the body portion SEM2-2. The lens portion SEM2-1 and the body portion SEM2-2 may be arranged in a line in the third direction, but are not limited to this. Further, the side surface of the lens portion SEM2-1 may be arranged in a line in the third direction with the sides of the connection electrode 112.

The height of the reflective layer REF may be lower than the height of the planarization layer 113. The height of the reflective layer REF can be defined as the distance from the top surface of the interlayer insulating layer 111 to the top surface of the reflective layer REF, and the height of the planarization layer 113 may be defined as the distance from the top surface of the interlayer insulating layer 111 to the top surface of the planarization layer 113. Accordingly, the common electrode CE and the reflective layer REF may not be in contact with each other.

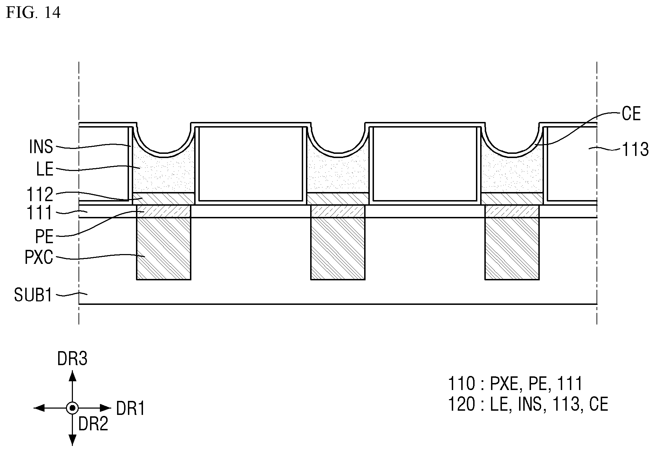

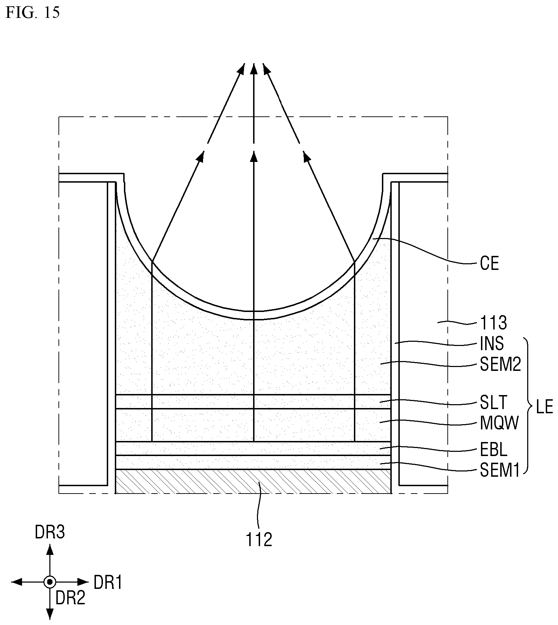

FIG. 14 is a cross-sectional view schematically illustrating a display area of a display device according to another embodiment. FIG. 15 is an enlarged view illustrating the common electrode and light-emitting element shown in FIG. 14 in detail.

FIGS. 14 and 15 are different from the embodiments of FIGS. 12 and 13 in that the lens shape of the top surface of the light-emitting element LE is convex downward. Furthermore, FIGS. 14 and 15 are different from the embodiments of FIGS. 10 and 11 in that the diameter of the connection electrode 112 and the diameter of the light-emitting element LE are the same.

Hereinafter, the description referring to FIGS. 14 and 15 will focus on differences from the embodiments of FIGS. 12 and 13.

Referring to FIGS. 14 and 15, the top surface of the light-emitting element LE may have a lens shape. The top surface of the light-emitting element LE has a convex shape toward the first substrate SUB1. The top surface of the light-emitting element LE has a convex shape toward the first substrate SUB1. The first common electrode CE has a convex shape downwardly along the top surface of the light-emitting element LE.

The light-emitting element LE may include a first semiconductor layer SEM1, an electron-blocking layer EBL, an active layer MQW, a superlattice layer SLT, and a second semiconductor layer SEM2.

The second semiconductor layer SEM2 may have a downwardly convex lens-shaped top surface, thereby concentrating light emitted from the active layer MQW and improving the front light emission effect. In another variant, a reflective layer may be located on the side of each of the light-emitting elements LE on the insulating layer INS, on the top surface of the connection electrodes 112 that do not overlap the light-emitting element LE, and on the side of the connection electrode 112. As described with reference to FIG. 13, the height of the reflective layer may be lower than the height of the planarization layer 113. Accordingly, the common electrode CE and the reflective layer may not contact each other.

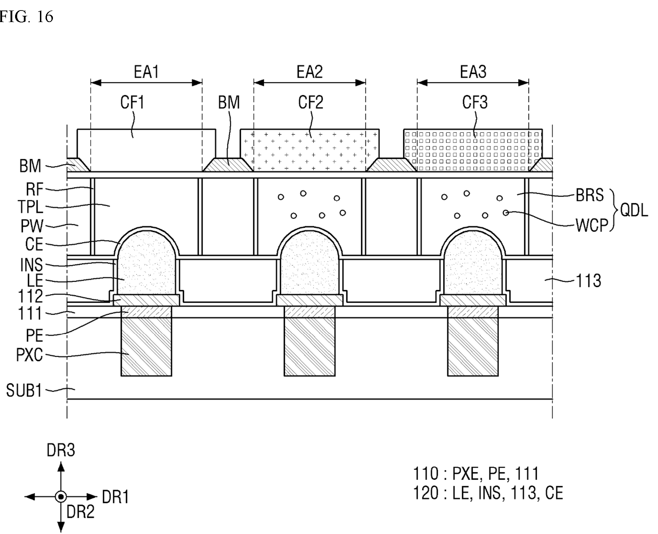

FIG. 16 is a cross-sectional view schematically illustrating a display device including a wavelength conversion layer and a color filter layer according to another embodiment.

Referring to FIG. 16, the display device 10 may further include a semiconductor circuit board 110, a light-emitting element layer 120, a wavelength conversion layer QDL, and a color filter layer CFL.

Because the semiconductor circuit board 110 and the light-emitting element layer 120 are the same as the semiconductor circuit board 110 and the light-emitting element layer 120 described in FIGS. 6 and 7, overlapping descriptions will be omitted.

The light-emitting element layer 120 may include a light-emitting element LE, an insulating layer INS, a common electrode CE, and a wavelength conversion layer QDL.

Each of the plurality of pixels PX may include a plurality of light-emitting areas EA1, EA2, and EA3 that emit light. Each of the plurality of light-emitting areas EA1, EA2, and EA3 may include a light-emitting element LE that emits a first light.

Each of the first light-emitting areas EA1 refers to an area that emits the first light. Each of the first light-emitting areas EA1 may output the first light output from the light-emitting element LE as is. The first light may be light in a blue wavelength band. The blue wavelength band may be about 370 nm to about 460 nm, but embodiments of the present specification are not limited thereto.

Each of the first light-emitting areas EA1 may include a light-emitting element LE, a light-transmitting layer TPL, and a first color filter CF1. The light-emitting element LE, the light-transmitting layer TPL, and the first color filter CF1 may overlap in the third direction DR3. The light-transmitting layer TPL may transmit the first light output from the light-emitting element LE as is, and the first color filter CF1 may transmit the first light. Therefore, each of the first light-emitting areas EA1 may emit the first light.

Each of the second light-emitting areas EA2 may include a light-emitting element LE, a wavelength conversion layer QDL, and a second color filter CF2. The light-emitting element LE, the wavelength conversion layer QDL, and the second color filter CF2 may overlap in the third direction DR3. The wavelength conversion layer QDL may emit the first light output from the light-emitting element LE by converting a portion of the first light into the fourth light. For example, the fourth light may be light in a yellow wavelength band. The fourth light may be a light including both a green wavelength band and a red wavelength band. That is, the fourth light may be a mixture of the second light and the third light. The second color filter CF2 may transmit the second light. Therefore, each of the second light-emitting areas EA2 may emit the second light.

Each of the third light-emitting areas EA3 may include a light-emitting element LE, a wavelength conversion layer QDL, and a third color filter CF3. The light-emitting element LE, the wavelength conversion layer QDL, and the third color filter CF3 may overlap in the third direction DR3. The wavelength conversion layer QDL may emit the first light output from the light-emitting element LE by converting a portion of the first light into the fourth light. The third color filter CF3 may transmit third light. Therefore, each of the second light-emitting areas EA3 may emit the third light.

The area of the light-transmitting layer TPL and the area of the wavelength conversion layer QDL may each be larger than the area of the light-emitting element LE. The areas of each of the first color filter CF1, the second color filter CF2, and the third color filter CF3 may be larger than the area of the light-emitting element LE. In addition, the areas of each of the first color filter CF1, the second color filter CF2, and the third color filter CF3 are larger than the areas of the light-transmitting layer TPL and the wavelength conversion layer QDL, respectively.

In the first light-emitting area EA1, the light-emitting element LE may be completely covered by the light-transmitting layer TPL, and the light-transmitting layer TPL may be completely covered by the first color filter CF1. Further, in the second light-emitting area EA2, the light-emitting element LE may be completely covered by the wavelength conversion layer QDL, and the wavelength conversion layer QDL may be completely covered by the second color filter CF2. Furthermore, in the third light-emitting area EA3, the light-emitting element LE may be completely covered by the wavelength conversion layer QDL, and the wavelength conversion layer QDL may be completely covered by the third color filter CF3.

It is disclosed that the planar shape of the light-transmitting layer TPL, the planar shape of the wavelength conversion layer QDL, the planar shape of the first color filter CF1, the planar shape of the second color filter CF2, and the planar shape of the third color filter CF3 conform to the planar shape of the light-emitting element LE. For example, when the light-emitting element LE has a rectangular planar shape, the light-transmitting layer TPL, the wavelength conversion layer QDL, the first color filter CF1, the second color filter CF2, and the third color filter CF3 may each have a rectangular planar shape. Alternatively, the light-emitting element LE may have a polygonal, circular, oval, or irregular shape other than a square or rectangle, in which case the light-transmitting layer TPL, the wavelength conversion layer QDL, the first color filter CF1, the second color filter CF2, and the third color filter CF3 may also have a polygonal, circular, oval, or irregular shape other than a square or rectangle.

Alternatively, the planar shape of the light-transmitting layer TPL, the planar shape of the wavelength conversion layer QDL, the planar shape of the first color filter CF1, the planar shape of the second color filter CF2, and the planar shape of the third color filter CF3 may not conform to the planar shape of the light-emitting element LE. In this case, the planar shape of the light-transmitting layer TPL, the planar shape of the wavelength conversion layer QDL, the planar shape of the first color filter CF1, the planar shape of the second color filter CF2, and the planar shape of the third color filter CF3 may each be different from the planar shape of the light-emitting element LE. Further, the planar shape of the light-transmitting layer TPL and the planar shape of the wavelength conversion layer QDL may each be different from the planar shape of the first color filter CF1, the planar shape of the second color filter CF2, and the planar shape of the third color filter CF3.

The light-transmitting layer TPL may include a light-transmitting organic material. For example, the light-transmitting layer TPL may include an epoxy-based resin, an acrylic-based resin, a cardo-based resin, or an imide-based resin.

The wavelength conversion layer QDL may completely cover the light-emitting element LE in each of the second and third light-emitting areas EA2 and EA3.

The wavelength conversion layer QDL may include a base resin BRS and wavelength conversion particles WCP. The wavelength conversion particle WCP may convert the first light emitted from the light-emitting element LE into the fourth light. For example, the first wavelength conversion particle may convert light in the blue wavelength band into light in the yellow wavelength band. The first wavelength conversion particle may be a quantum dot (QD), a quantum rod, a fluorescent material, or a phosphorescent material. The quantum dots may include Group IV nanocrystals, Group II-VI compound nanocrystals, Group III-V compound nanocrystals, Group IV-VI nanocrystals, or combinations thereof.

The quantum dots may include a core and a shell overcoating the core. The core is not limited thereto, but may be at least one of, for example, CdS, CdSe, CdTe, ZnS, ZnSe, ZnTe, GaN, GaP, GaAs, GaSb, AlN, AlP, AlAs, AlSb, InP, InAs, InSb, SiC, Ca, Se, In, P, Fe, Pt, Ni, Co, Al, Ag, Au, Cu, FePt, Fe₂O₃, Fe₃O₄, Si, or Ge. The shell is not limited thereto, but may be at least one of, for example, ZnS, ZnSe, ZnTe, CdS, CdSe, CdTe, HgS, HgSe, HgTe, AlN, AlP, AlAs, AlSb, GaN, GaP, GaAs, GaSb, GaSe, InN, InP, InAs, InSb, TlN, TlP, TlAs, TlSb, PbS, PbSe, or PbTe.

The wavelength conversion layer QDL may further include a scatterer for scattering light from the light-emitting element LE in a random direction. In this case, the scatterers may include metal oxide particles or organic particles. For example, the metal oxide may be titanium oxide (TiO₂), zirconium oxide (ZrO₂), silicon dioxide (SiO₂), aluminium oxide (Al₂O₃), indium oxide (In₂O₃), zinc oxide (ZnO), or tin oxide (SnO₂). Furthermore, the organic particles may include acrylic resin or urethane resin. The diameter of the scatterer may be about a few to tens of nanometers.

A partition wall PW is located on the common electrode CE of the display area DPA and may compartmentalize a plurality of light-emitting areas EA1, EA2, and EA2 and a non-light-emitting area. The partition wall PW is arranged to extend in the first direction DR1 and the second direction DR2 and may be formed in a grid-like pattern throughout the display area DPA. Further, the partition wall PW may not overlap with the plurality of light-emitting areas EA1, EA2, and EA3, and may overlap with the non-light-emitting area NEA.

The partition wall PW may include a plurality of openings OP1, OP2, and OP3 defining the light-emitting area. The plurality of openings OP1, OP2, and OP3 may include a first opening OP1 overlapping the first light-emitting area EA1, a second opening OP2 overlapping the second light-emitting area EA2, and a third opening OP3 overlapping the third light-emitting area EA3. Here, the plurality of openings OP1, OP2, and OP3 may correspond to the plurality of light-emitting areas EA1, EA2, and EA3. That is, the first opening OP1 corresponds to the first light-emitting area EA1, the second opening OP2 corresponds to the second light-emitting area EA2, and the third opening OP3 corresponds to the third light-emitting area EA3.

The partition wall PW may serve to provide a space for the wavelength conversion layer QDL to be formed. To this end, the partition wall PW may be made of a predetermined thickness, for example, the thickness of the partition wall PW may be in the range of 1 µm to 10 µm. The partition wall PW may include an organic insulating material to have a predetermined thickness. The organic insulating material may include, for example, an epoxy-based resin, an acrylic-based resin, a cardo-based resin, or an imide-based resin.

A reflective layer RF may be located inside the space formed by the partition wall PW. The reflective layer RF may be referred to as a partition wall reflective layer RF to distinguish it from the reflective layer REF located on the side of the light-emitting element LE with reference to FIGS. 8 and 9.

The partition wall reflective layer RF may directly contact the partition wall PW and the wavelength conversion layer QDL. The partition wall reflective layer RF serves to reflect light emitted from the light-emitting element LE, which travels in a lateral direction rather than an upward direction. The partition wall reflective layer RF may include a highly reflective metal material, such as aluminium (Al). The plurality of color filters CF1, CF2, and CF3 may be located on the partition wall PW, the light-transmitting layer TPL, and the wavelength conversion layer QDL. The plurality of color filters CF1, CF2, and CF3 may be arranged to overlap the plurality of pixel circuit portions PXC and wavelength conversion layers QDL. The plurality of color filters CF1, CF2, and CF3 may include a first color filter CF1, a second color filter CF2, and a third color filter CF3.

The plurality of color filters CF1, CF2, and CF3 may include first color filters CF1, second color filters CF2, and third color filters CF3.

Each of the first color filters CF1 may be located on the light-transmitting layer TPL in the first light-emitting area EA1. Each of the first color filters CF1 may transmit first light and absorb or block second light and third light. For example, each of the first color filters CF1 may transmit light in the blue wavelength band and absorb or block light in the green and red wavelength bands. Therefore, each of the first color filters CF1 may transmit the first light emitted from the light-emitting element LE. That is, the first light emitted from the light-emitting element LE in the first light-emitting area EA1 is not converted by a separate wavelength conversion layer and may transmit the first color filter CF1 through the light-transmitting layer TPL. Accordingly, each of the first light-emitting areas EA1 may emit first light.

Each of the second color filters CF2 may be located on the wavelength conversion layer QDL in the second light-emitting area EA2. Each of the second color filters CF2 may transmit second light and absorb or block first light and third light. For example, each of the second color filters CF2 may transmit light in the green wavelength band and absorb or block light in the blue and red wavelength bands. Therefore, each of the second color filters CF2 may absorb or block the first light that is not converted by the wavelength conversion layer QDL among the first light emitted from the light-emitting element LE. In addition, each of the second color filters CF2 may transmit the second light corresponding to the green wavelength band and absorb or block the third light corresponding to the blue wavelength band among the fourth light converted by the wavelength conversion layer QDL. Accordingly, each of the second light-emitting areas EA1 may emit the second light.

Each of the third color filters CF3 may be located on the wavelength conversion layer QDL in the third light-emitting area EA3. Each of the third color filters CF3 may transmit third light and absorb or block first light and second light. For example, each of the third color filters CF3 may transmit light in the red wavelength band and absorb or block light in the blue and green wavelength bands. Therefore, each of the third color filters CF3 may absorb or block the first light that is not converted by the wavelength conversion layer QDL among the first light emitted from the light-emitting element LE. In addition, each of the third color filters CF3 may transmit the third light corresponding to the red wavelength band among the fourth light converted by the wavelength conversion layer QDL and absorbs the second light corresponding to the green wavelength band. Accordingly, each of the third light-emitting areas EA3 may emit the third light.

A black matrix/light-blocking member BM may be located between the plurality of color filters CF1, CF2, and CF3. For example, the black matrix BM may be located between the first color filter CF1 and the second color filter CF2, between the second color filter CF2 and the third color filter CF3, and between the first color filter CF1 and the third color filter CF3. The black matrix BM may include an inorganic black pigment, such as carbon black or an organic black pigment.

In addition, the plurality of color filters CF1, CF2, and CF3 may partially overlap with neighboring color filters. For example, the first color filter CF1 may have an area partially overlapping with the neighboring second color filter CF2, and the second color filter CF2 may have an area that partially overlaps with the neighboring first color filter CF1 or third color filter CF3, and the third color filter CF3 may have an area that partially overlaps with the neighboring first color filter CF1 or second color filter CF2. In this way, the area formed by overlapping the plurality of color filters CF1, CF2, and CF3 may serve as the black matrix BM that blocks light leakage due to the overlap, so the black matrix BM may be omitted.

The light blocking member BM may be located on the partition wall PW. The light-blocking member BM may block the transmission of light by overlapping the non-light-emitting area NEA. The light-blocking member BM may be arranged in a roughly grid-like arrangement in plan, similar to the partition wall PW. The light-blocking member BM may overlap the partition wall PW, and might not overlap the light-emitting areas EA1, EA2, and EA3.

In one embodiment, the light blocking member BM may include an organic light-blocking material, and may be formed through a coating-and-exposure process of the organic light-blocking material. The light-blocking member BM may include a dye or pigment having light-blocking properties and may be a black matrix. The light-blocking member BM may at least partially overlap with adjacent color filters CF1, CF2, and CF3, and the color filters CF1, CF2, and CF3 may overlap with at least a portion of the light-blocking member BM.

When the light-blocking member BM is located on the partition wall PW, at least a portion of external light is absorbed by the light-blocking member BM. Therefore, color distortion caused by external light reflection may be reduced. Furthermore, the light-blocking member BM may prevent light from intruding between adjacent light-emitting areas and causing color mixing, thereby further improving the color reproduction rate.

A protective layer BF may be located below the plurality of color filters CF1, CF2, and CF3 and the light-blocking member BM. The protective layer BF may be located on the partition wall PW, the light-transmitting layer TPL, and the wavelength conversion layer QDL. One surface, for example, the top surface, of the protective layer BF may contact the lower surfaces of the plurality of color filters CF1, CF2, and CF3 and the light-blocking member BM, respectively. In addition, the other surface, for example, the lower surface, which is opposite to one surface of the protective layer BF, may contact the top surface of the partition wall PW, the light-transmitting layer TPL, and the wavelength conversion layer QDL, respectively. The protective layer BF may include an inorganic insulating material. For example, the protective layer BF may include, but is not limited to, silicon oxide (SiOx), silicon nitride (SiNx), silicon oxynitride (SiOxNy), aluminium oxide (AlxOy), aluminium nitride (AlN), or the like. The protective layer BF may have a predetermined thickness, for example, in the range of 0.01 to 1 µm. However, it is not limited to this.

Hereinafter, a manufacturing process of the display device 10 according to one embodiment will be described with reference to other drawings.

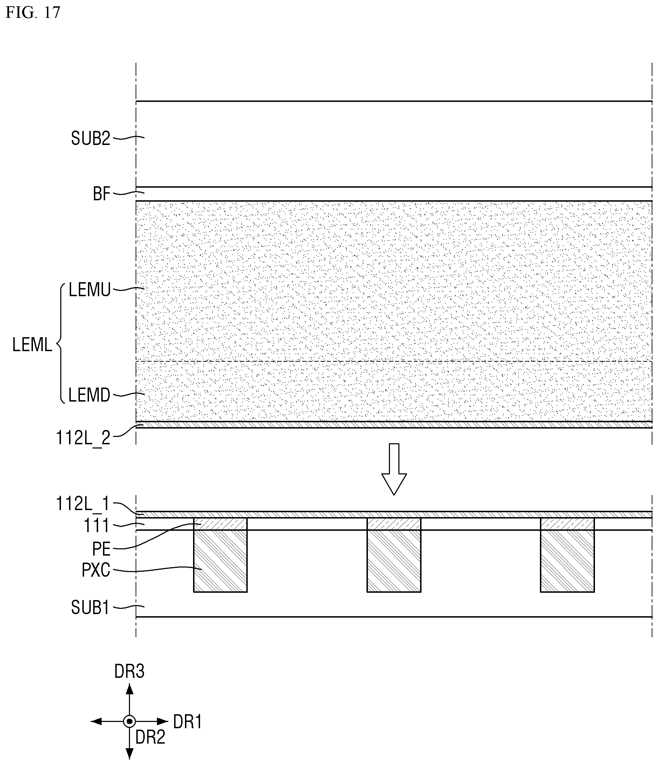

FIG. 17 to 26 are cross-sectional views to illustrate a method of manufacturing a display device according to one embodiment.

FIGS. 17 to 26 illustrate the structure according to the formation order of each layer of the display device 10 as a cross-sectional view and a plan view, respectively. FIGS. 17 to 26 mainly illustrate the manufacturing process of a light-emitting body portion LEP, and may broadly correspond to the cross-sectional view of FIG. 6 respectively.

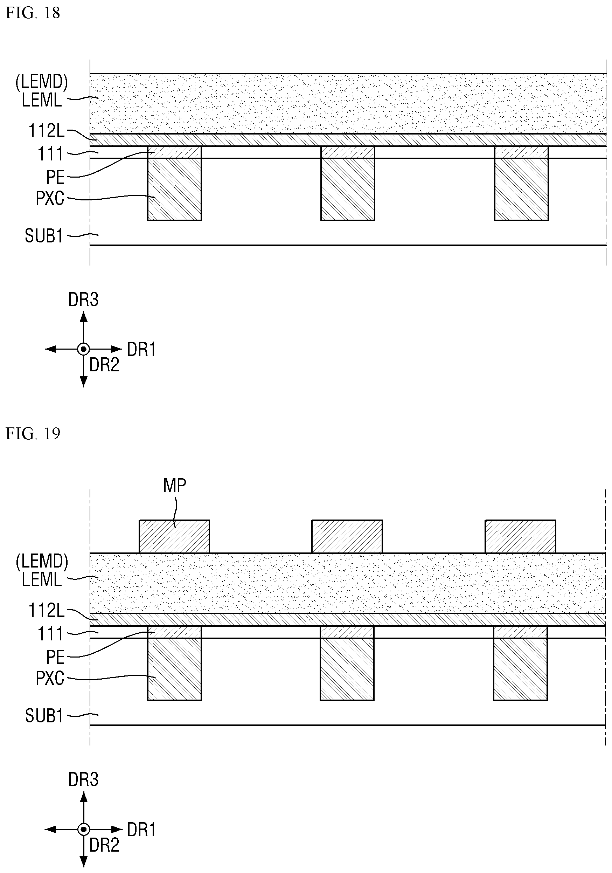

As shown in FIGS. 17 and 18, a first substrate SUB1 having a pixel electrode PE and a second substrate SUB2 having a light-emitting material layer LEML are bonded with a connection electrode layer 112L, and the second substrate SUB2 is removed.

First, referring to FIG. 17, a first connection electrode layer 112L_1 is formed on the first substrate SUB1 having a pixel electrode PE, and a second connection electrode layer 112L_2 is formed on the light-emitting material layer LEML of the second substrate SUB2.

For example, first, an interlayer insulating layer 111 is formed on the first substrate SUB1 on which the pixel electrodes PE are not located. The top surface of the interlayer insulating layer 111 and the top surface of each of the pixel electrodes PE may be flat. That is, the height difference between the top surface of the first substrate SUB1 and the top surface of the pixel electrode PE may be substantially eliminated by the interlayer insulating layer 111. The interlayer insulating layer 111 may be formed of an inorganic film, such as a silicon oxide film (SiO₂), an aluminium oxide film (Al₂O₃), or a hafnium oxide film (HfOₓ).

Then, the first connection electrode layer 112L_1 is deposited on the pixel electrodes PE and the interlayer insulating layer 111. The first connection electrode layer 112L_1 may include at least one of gold (Au), copper (Cu), tin (Sn), silver (Ag), aluminium (Al), or titanium (Ti). For example, the first connection electrode layer 112L_1 may include a 9:1 alloy of gold and tin, an 8:2 alloy, or a 7:3 alloy, or may include an alloy of copper, silver, and tin (SAC305).

In addition, a buffer film BF may be formed on one surface of the second substrate SUB2. The second substrate SUB2 may be a silicon substrate or a sapphire substrate. The buffer film BF may be formed of an inorganic film, such as a silicon oxide film (SiO₂), an aluminium oxide film (Al₂O₃), or a hafnium oxide film (HfOₓ).

The light-emitting material layer LEML may be located on the buffer film BF. The light-emitting material layer LEML may include a first semiconductor material layer LEMD and a second semiconductor material layer LEMU. The second semiconductor material layer LEMU may be located on the buffer film BF, and the first semiconductor material layer LEMD may be located on the second semiconductor material layer LEMU.

The first semiconductor material layer LEMD may include a first semiconductor layer SEM1, an electron-blocking layer EBL, an active layer MQW, a superlattice layer SLT, and a second semiconductor layer SEM2, as shown in FIG. 7. The second semiconductor material layer LEMU may be a semiconductor layer that is not doped with a dopant, that is, an undoped semiconductor layer. For example, the second semiconductor material layer LEMU may be undoped-GaN, which is not doped with a dopant.

The second connection electrode layer 112L_2 may be deposited on the first semiconductor material layer LEMD. The second connection electrode layer 112L_2 may include the same material as a first connection electrode layer 112L_1 but is not limited thereto.

The second connection electrode layer 112L_2 may include at least one of gold (Au), copper (Cu), tin (Sn), silver (Ag), aluminium (Al), or titanium (Ti). For example, the second connection electrode layer 112L_2 may include a 9:1 alloy of gold and tin, an 8:2 alloy, or a 7:3 alloy, or may include an alloy of copper, silver, and tin (SAC305).

Next, as shown in FIG. 18, the first connection electrode layer 112L_1 and the second connection electrode layer 112L_2 are bonded, and the second substrate SUB2 is removed.

For example, the first connection electrode layer 112L_1 of the first substrate SUB1 and the second connection electrode layer 112L_2 of the second substrate SUB2 are brought into contact. Then, one connection electrode layer 112L is formed by melting and bonding the first connection electrode layer 112L_1 and the second connection electrode layer 112L_2 at a predetermined temperature. That is, the connection electrode layer 112L is located between the pixel electrodes PE of the first substrate SUB1 and the light-emitting material layer LEML of the second substrate SUB2, and may serve as a bonding metal layer to bond the pixel electrodes PE of the first substrate SUB1 and the light-emitting material layer LEML of the second substrate SUB2. In one embodiment, connection electrodes were formed on the first substrate SUB1 and the second substrate SUB2 and bonded to each other. However, the first substrate SUB1 and the second substrate SUB2 may be bonded by forming a connection electrode only on either the first substrate SUB1 or the second substrate SUB2.

After bonding the first connection electrode layer 112L_1 and the second connection electrode layer 112L_2, the second substrate SUB2 and the buffer film BF may be removed by a polishing process, such as a chemical mechanical polishing (CMP) process and/or an etching process. Furthermore, the second semiconductor material layer LEMU of the light-emitting material layer LEML may be removed through a polishing process, such as a CMP process.

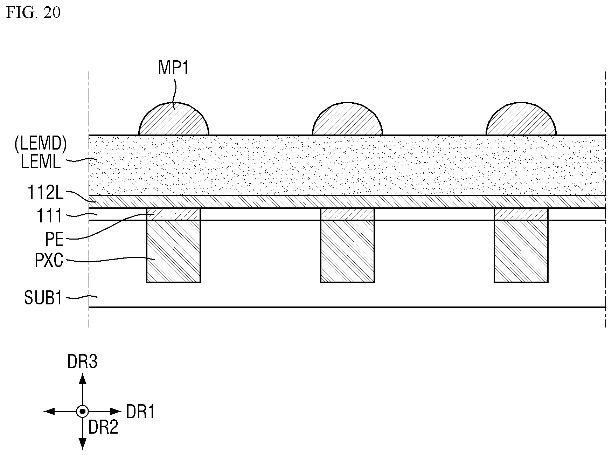

As shown in FIGS. 19 and 20, a lens-shaped first mask pattern MP1 is patterned on the light-emitting material layer LEML. To this end, first, as shown in FIG. 19, a photosensitive polymer mask pattern MP is patterned through a photolithography process. Thereafter, the first mask pattern MP1 is formed into a lens shape using a reflow process.

The reflow process melts the polymer material into a liquefied state by heating the patterned photosensitive polymer mask to a temperature exceeding the melting point of the polymer material for a predetermined period of time. At this time, the surface tension of the liquefied material will shape it into a lens shape with a smooth, curved surface. After the reflow process, as shown in FIG. 19, the patterned photosensitive polymer mask pattern MP may be molded into the lens-shaped first mask pattern MP1 as shown in FIG. 20.

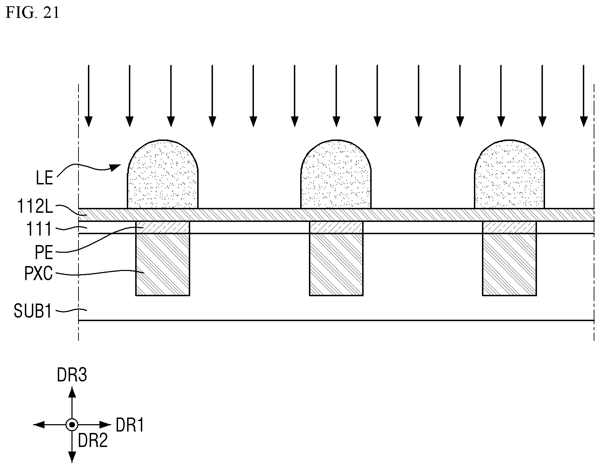

Next, referring to FIG. 21, a light-emitting element LE having a lens-shaped top surface is formed using a lens-shaped first mask pattern MP1.

For example, an area on the first semiconductor material layer LEMD where the first mask pattern MP1 is not located is first etched until the connection electrode layer 112L is exposed. Accordingly, the top surface of the first semiconductor material layer LEMD may have a lens shape with a smooth curved surface like the first mask pattern MP1.

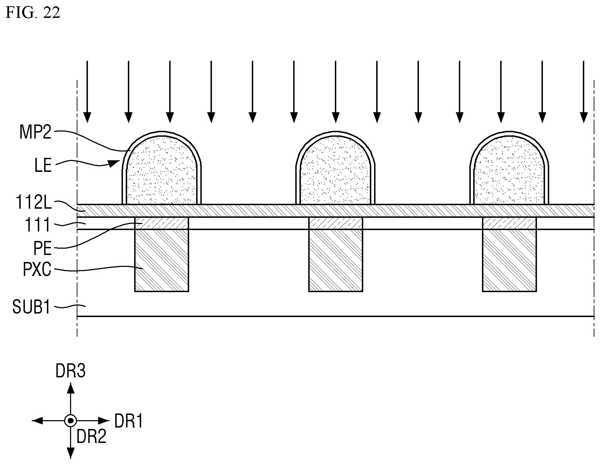

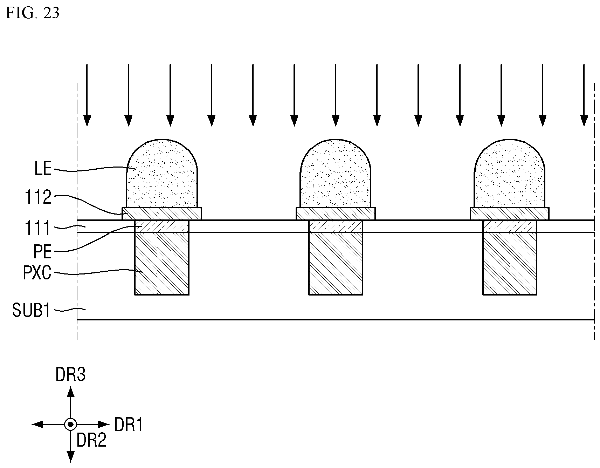

Next, referring to FIGS. 22 and 23, the connection electrode 112 is formed through a photolithography process and an etching process.

For example, a photosensitive polymer mask pattern MP surrounding the light-emitting element LE is patterned through a photolithography process. Thereafter, the connection electrode 112 is formed by etching the connection electrode layer 112L until the interlayer insulating layer 111 is exposed. At this time, the upper edge of the connection electrode 112 may have a curvature.

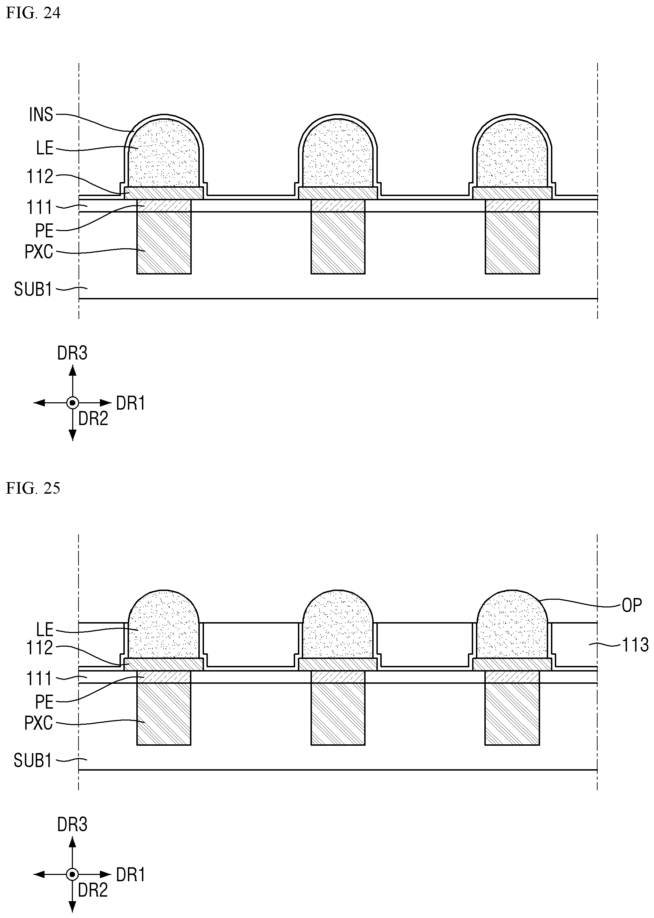

Next, referring to FIGS. 24 and 25, an insulating layer INS and a planarization layer 113 are formed on the side of the light-emitting element LE.

For example, referring to FIG. 24, the insulating layer INS is deposited to cover the entire surface of the first substrate SUB1 on which the light-emitting element LE is located. The insulating layer INS may be formed of an inorganic film, such as a silicon oxide film (SiO₂), an aluminium oxide film (Al₂O₃), or a hafnium oxide film (HfOₓ) but is not limited thereto.

The insulating layer INS is formed on the top and side surfaces of each light-emitting element LE and the interlayer insulating layer 111 on the side surface of the connection electrode 112.

As shown in FIG. 25, a planarization layer 113 is formed on the first substrate SUB1 on which the insulating layer INS is formed. The planarization layer 113 may be located in an area of the light-emitting element LE excluding the area where the insulating layer INS is to be opened. The planarization layer 113 may be formed of an organic film, such as an acrylic resin, an epoxy resin, a phenolic resin, a polyamide resin, a polyimide resin, or the like but is not limited to this.

Then, the insulating layer INS located on the top surface of the light-emitting element LE that is not covered by the planarization layer 113 is removed. That is, an opening OP is formed in the upper region of the light-emitting element LE by etching the insulating layer INS, thereby exposing the upper region of the light-emitting element LE.

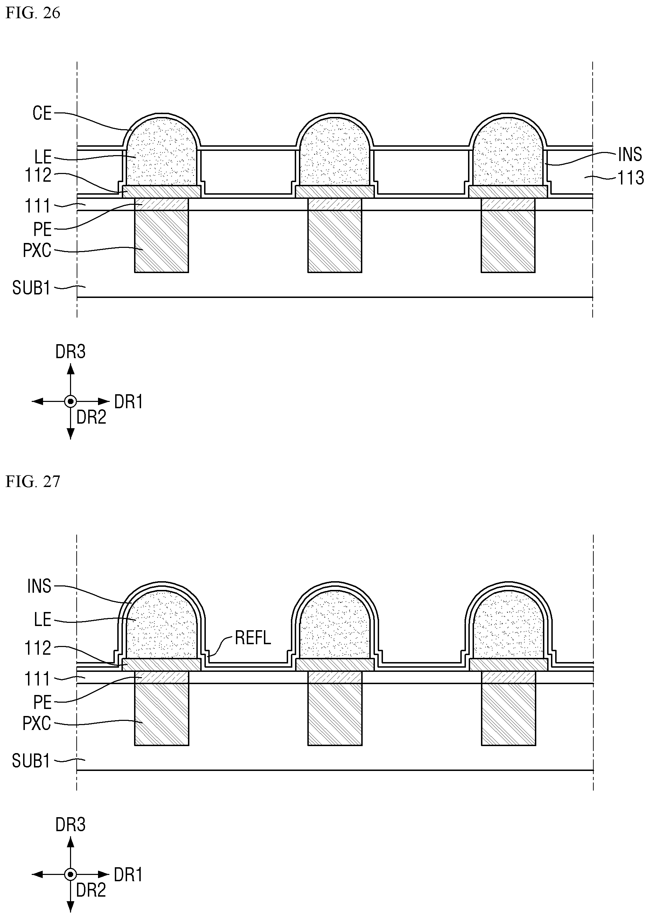

Next, as shown in FIG. 26, a common electrode CE is formed on the top surface of the light-emitting element LE exposed by the opening OP and the planarization layer 113.

The common electrode CE may include a transparent conductive oxide (TCO), such as indium tin oxide (ITO) or indium zinc oxide (IZO).

FIGS. 27 to 30 are cross-sectional views to illustrate a method of manufacturing a display device according to another embodiment.

FIGS. 27 to 30 illustrate the structure according to the formation order of each layer of the display device 10 as a cross-sectional view and a plan view, respectively. FIGS. 27 to 30 mainly illustrate manufacturing processes according to other embodiments after the manufacturing processes described in FIGS. 17 to 24, and each of these may broadly correspond to the cross-sectional view of FIG. 8.

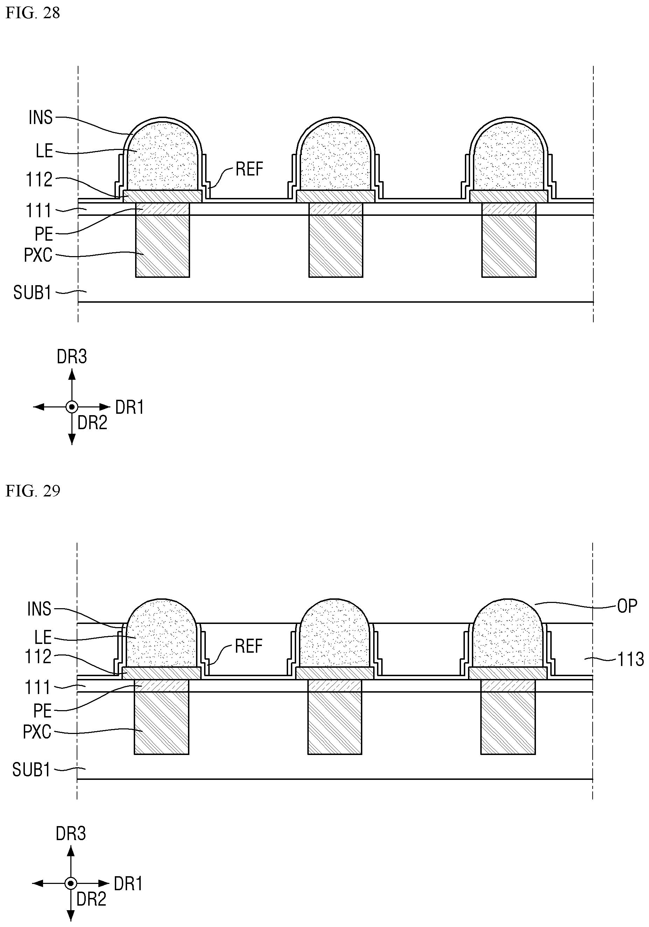

As shown in FIGS. 27 and 28, a reflective material layer REFL is deposited on the insulating layer INS to cover the first substrate SUB1.

Then, a large voltage difference is formed in the third direction DR3 without a separate mask, and the reflective material layer REFL is etched using an etching material. In this case, the etching material moves in the third direction DR3 by voltage control, that is, moving from the top to the bottom, and may etch the reflective material layer REFL. As a result, as shown in FIG. 28, the reflective material layer REFL located on the horizontal plane defined by the first direction DR1 and the second direction DR2 may be removed, while the reflective material layer REFL located in the vertical plane defined by the third direction DR3 may not be removed. Therefore, the reflective material layer REFL located on the top surface of the light-emitting element LE, and on the top surface of the insulating layer INS at which the light-emitting element LE is not located, may be removed. The reflective material layer REFL located on the side surfaces of the light-emitting element LE may remain. The reflective material layer REFL that is not removed and remains on the side surfaces of the light-emitting element LE may be referred to as a reflective layer REF. The reflective layer REF may be formed to surround the side of the light-emitting element LE on the insulating layer INS.

Next, as shown in FIG. 29, a planarization layer 113 is formed on the first substrate SUB1 on which the insulating layer INS and the reflective layer REF are formed. The planarization layer 113 may be located in an area of the light-emitting element LE excluding the area where the insulating layer INS is to be opened. The planarization layer 113 may be formed lower than the height of the light-emitting element LE. The planarization layer 113 may be formed higher than the reflective layer REF. Therefore, the common electrode CE and the reflective layer REF to be formed later may not contact each other. The planarization layer 113 may be formed of an organic film, such as an acrylic resin, an epoxy resin, a phenolic resin, a polyamide resin, a polyimide resin, or the like but is not limited to this.

Then, the insulating layer INS located on the top surface of the light-emitting element LE that is not covered by the planarization layer 113 is removed. That is, an opening OP is formed in the upper region of the light-emitting element LE by etching the insulating layer INS, thereby exposing the upper region of the light-emitting element LE.

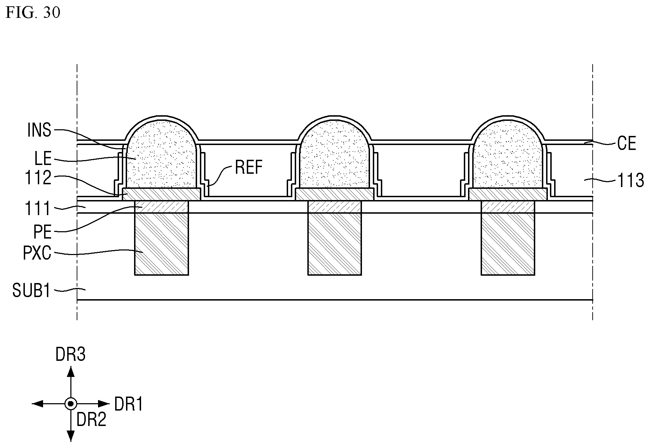

Next, as shown in FIG. 30, a common electrode CE is formed on the top surface of the light-emitting element LE exposed by the opening OP and the planarization layer 113.

The common electrode CE may include a transparent conductive oxide (TCO), such as indium tin oxide (ITO) or indium zinc oxide (IZO).

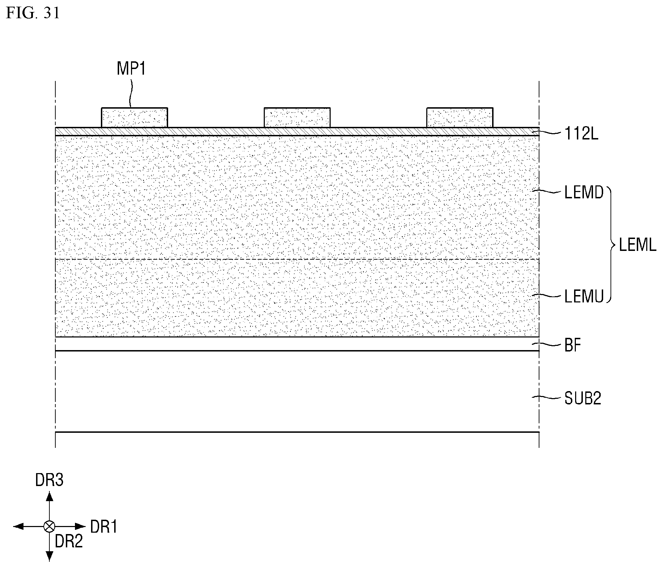

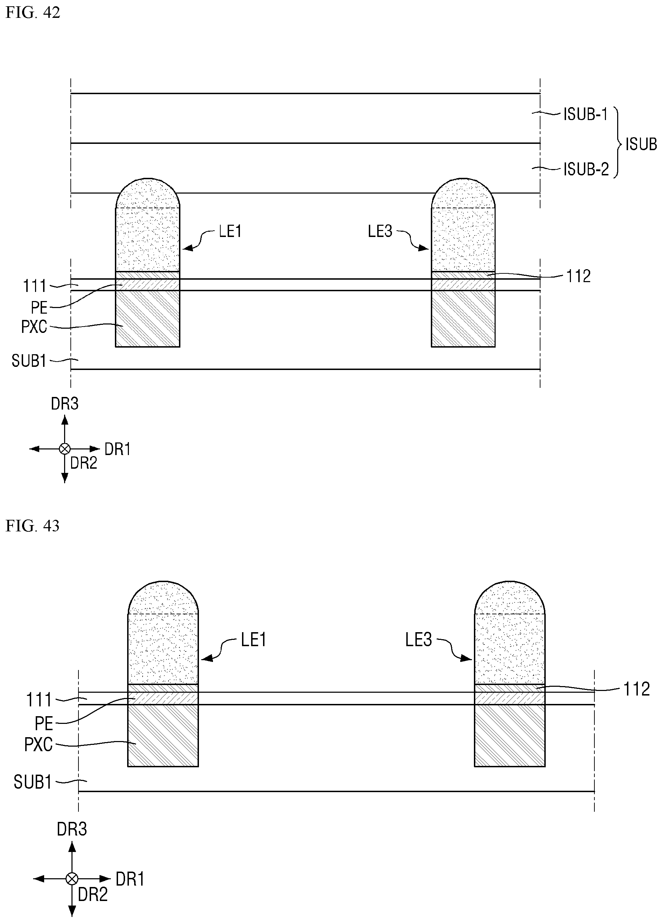

FIGS. 31 to 43 are cross-sectional views to illustrate a method of manufacturing a display device according to one or more other embodiments.

FIGS. 31 to 43 illustrate the structure according to the formation order of each layer of the display device 10 as a cross-sectional view and a plan view, respectively. FIGS. 31 to 43 mainly illustrate the manufacturing process of a light-emitting body portion LEP, and each may broadly correspond to the cross-sectional view of FIG. 12.

Referring to FIG. 31, a light-emitting material layer LEML and a connection electrode layer 112L are formed on the base substrate BSUB.

First, a second substrate SUB2 is prepared. The second substrate SUB2 may be a sapphire substrate (Al₂O₃) or a silicon wafer containing silicon. However, the present disclosure is not limited to this, and the case where the second substrate SUB2 is a sapphire substrate will be described in one or more embodiments.

A second semiconductor material layer LEMU and a light-emitting material layer LEML are sequentially formed on the second substrate SUB2.

As shown in FIG. 13, the first semiconductor material layer LEMD may include a first semiconductor layer SEM1, an electron-blocking layer EBL, an active layer MQW, a superlattice layer SLT, and a second semiconductor layer SEM2.

The light-emitting material layer LEML grown by the epitaxial method may be formed by growing a seed crystal. Here, the method of forming the light-emitting material layer LEML may include electron beam deposition, physical vapor deposition (PVD), chemical vapor deposition (CVD), plasma laser deposition (PLD), dual thermal vapor deposition, dual-type thermal evaporation, sputtering, metal organic chemical vapor deposition (MOCVD), or the like, and may be formed by metal organic chemical vapor deposition (MOCVD). However, it is not limited to this.

The precursor material for forming the light emitting material layer LEML is not particularly limited within a range that may be conventionally selected to form the target material. In one example, the precursor material may be a metal precursor containing an alkyl group, such as a methyl group or an ethyl group. For example, it may be a compound, such as trimethyl gallium (Ga(CH₃)₃), trimethyl aluminium (Al(CH₃)₃), or triethyl phosphate ((C₂H₅)₃PO₄) but is not limited thereto.

For example, the second semiconductor material layer LEMU is formed on the second substrate SUB2. In the drawing, the second semiconductor material layer LEMU is illustrated as one more layer, but the present disclosure is not limited thereto, and a plurality of layers may be formed. The second semiconductor material layer LEMU may reduce the difference in lattice constant between the first semiconductor material layer LEMD and the base substrate BSUB. In one example, the second semiconductor material layer LEMU may include an undoped semiconductor, and may be a material that is not doped as n-type or p-type. In one embodiment, the second semiconductor material layer LEMU may be at least one of undoped InAlGaN, GaN, AlGaN, InGaN, AlN, or InN but is not limited thereto.

The first semiconductor material layer LEMD is formed on the second semiconductor material layer LEMU using the above-described method. The first semiconductor material layer LEMD is formed by sequentially forming a second semiconductor material layer, a superlattice material layer, an active material layer, an electron-blocking material layer, and a first semiconductor material layer.

Afterwards, a connection electrode layer 112L is formed on the first semiconductor material layer LEMD. The connection electrode layer 112L may include at least one of gold (Au), copper (Cu), tin (Sn), silver (Ag), aluminium (Al), or titanium (Ti). For example, the first connection electrode layer 112L_1 may include a 9:1 alloy, an 8:2 alloy, or a 7:3 alloy of gold and tin, or an alloy of copper, silver, and tin (SAC305).

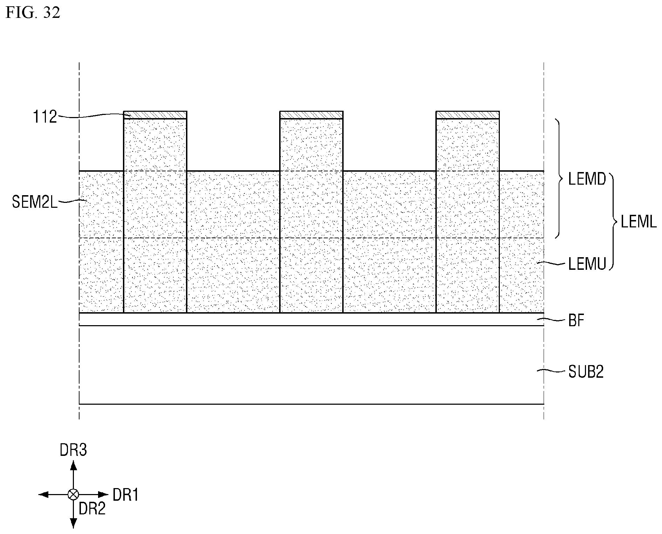

Next, referring to FIG. 32, a portion of the connection electrode layer 112L and the first semiconductor material layer LEMD are etched. The superlattice material layer, the active material layer, the electron-blocking material layer, and the first semiconductor material layer LEMD of the first semiconductor material layer LEMD may be etched.

For example, a photosensitive polymer mask pattern MP is formed on the first semiconductor material layer LEMD. The photosensitive polymer mask pattern MP may be a hard mask containing an inorganic material or a photoresist mask including an organic material. The photosensitive polymer mask pattern MP prevents the lower first semiconductor material layer LEMD being etched. Next, the first semiconductor material layer LEMD is etched (1^{st} etch) using the photosensitive polymer mask pattern MP until the second semiconductor material layer SEM2L of the first semiconductor material layer LEMD is exposed.

The semiconductor material layers may be etched by conventional methods. For example, the process for etching semiconductor material layers may be dry etching, wet etching, reactive ion etching (RIE), deep reactive ion etching (DRIE), or inductively coupled plasma reactive ion etching (ICP-RIE), or the like. In the case of dry etching, anisotropic etching is possible and may be suitable for vertical etching. When using the etching method described above, the etching etchant may be Cl₂ or O₂. However, it is not limited to this.

The light-emitting material layer LEML overlapping the photosensitive polymer mask pattern MP is not etched.

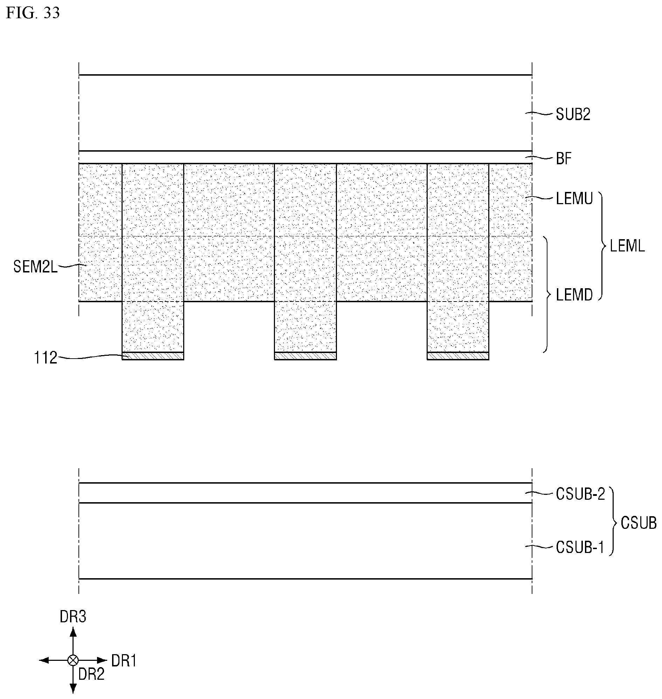

Referring to FIG. 33, the second substrate SUB2 is attached to a carrier substrate CSUB. For example, the etched first semiconductor material layer LEMD of the second substrate SUB2 is attached to the carrier substrate CSUB.

The carrier substrate CSUB may be composed of a first support layer CSUB-1, and a first adhesive layer CSUB-2 located on the first support layer CSUB-1. The first support layer CSUB-1 may be made of a transparent, mechanically stable material that allows light to penetrate. For example, the support layer may include a transparent polymer, such as polyester, polyacrylic, polyepoxy, polyethylene, polystyrene, polyethylene terephthalate, or the like. The first adhesive layer CSUB-2 may include an adhesive material for bonding the light-emitting element LE. For example, the adhesive material may include urethane acrylate, epoxy acrylate, polyester acrylate, or the like. The adhesive material may be a material whose adhesive strength changes as ultraviolet rays (UV) or heat are applied, and thus the first adhesive layer CSUB-2 may be suitably separated from the light-emitting element LE.

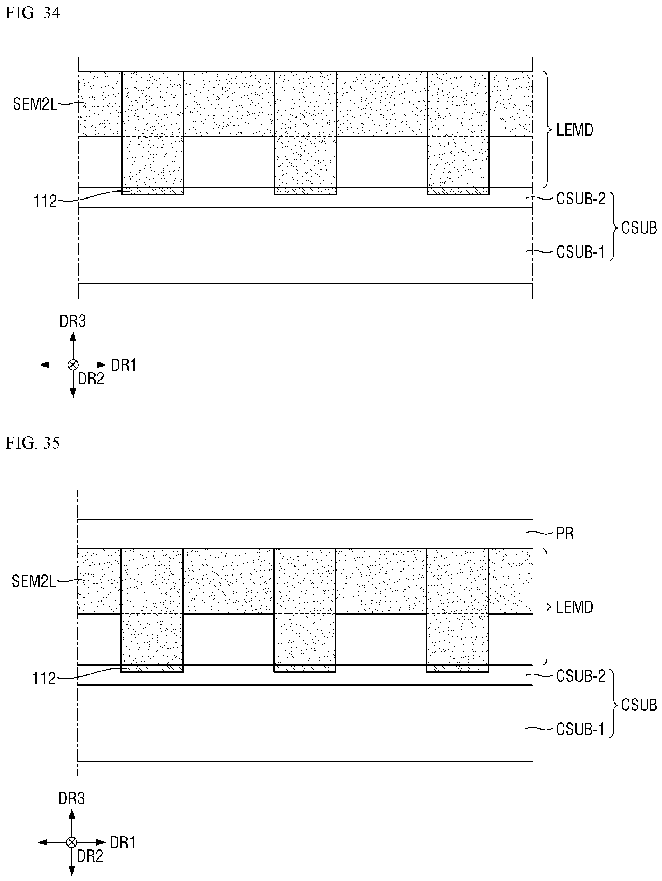

Next, referring to FIG. 34, a laser (1^{st} laser) is irradiated to the second substrate SUB2 to separate the light-emitting material layer LEML from the second substrate SUB2.

The process of separating the second substrate SUB2 may be performed using a laser lift off (LLO) process. The laser lift-off process uses a laser, and a KrF excimer laser (248 nm wavelength) may be used as a source. The energy density of the excimer laser is irradiated in the range of about 550 mJ/cm² to about 950 mJ/ cm², and the incident area may be in the range of about 50 x 50 µm ² to about 1 x 1 cm² but is not limited thereto. By irradiating the laser to the second substrate SUB2, the second substrate SUB2 may be separated from the light-emitting material layer LEML.

Thereafter, the second semiconductor material layer LEMU may be removed through a polishing process, such as a CMP process.

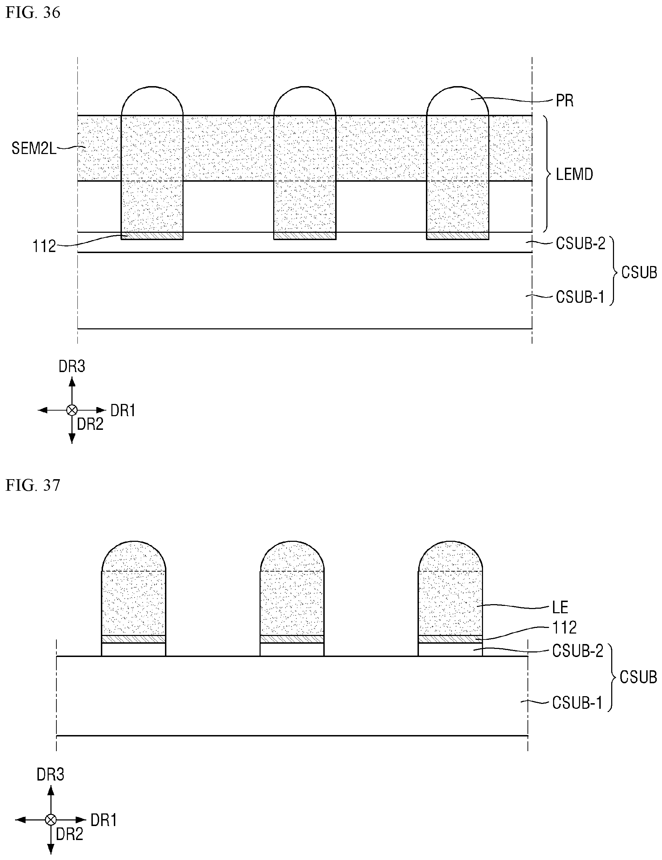

Next, referring to FIGS. 35 and 36, after forming a photosensitive polymer PR on the first semiconductor material layer LEMD by a photolithography process, the photosensitive polymer mask PR is applied to the lens using a reflow process to be molded into shape. Because the reflow process has been described above, repeated description is omitted.

Next, referring to FIG. 37, a light-emitting element LE having a lens-shaped top surface is formed using a lens-shaped photosensitive polymer mask pattern PR.

For example, the second semiconductor layer SEM2 and the adhesive layer CSUB-2 may be etched in the area where the photosensitive polymer mask pattern PR is not located on the first semiconductor material layer LEMD. Accordingly, the top surface of the first semiconductor material layer LEMD may have a lens shape with a smooth curved surface, such as the photosensitive polymer mask pattern PR. In other words, the top surface of the second semiconductor layer SEM2 is molded into a lens shape. A light-emitting element LE having a lens-shaped top surface is formed.

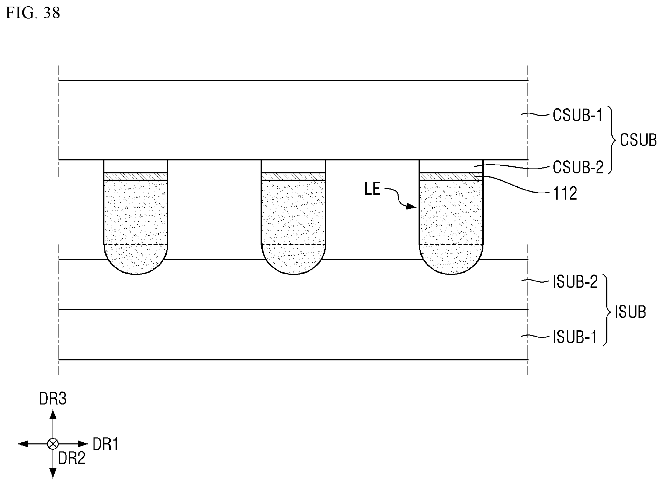

Referring to FIG. 38, the carrier substrate CSUB is aligned on an interposer substrate ISUB.

The interposer substrate ISUB may include a second support layer ISUB-1, and a second adhesive layer ISUB-2 located on the second support layer ISUB-1, similar to the carrier substrate CSUB.

The second support layer ISUB-1 may be made of a transparent, mechanically stable material that allows light to penetrate. For example, the support layer may include a transparent polymer, such as polyester, polyacrylic, polyepoxy, polyethylene, polystyrene, polyethylene terephthalate, or the like. The second adhesive layer ISUB-2 may include an adhesive material for bonding the light-emitting element LE. For example, the adhesive material may include urethane acrylate, epoxy acrylate, polyester acrylate, or the like. The adhesive material may be a material whose adhesive strength changes as ultraviolet rays (UV) or heat are applied, and thus the second adhesive layer ISUB-2 may be suitably separated from the light-emitting element LE.

The top surface of the lens-shaped light-emitting element LE may be located on the second adhesive layer ISUB-2.

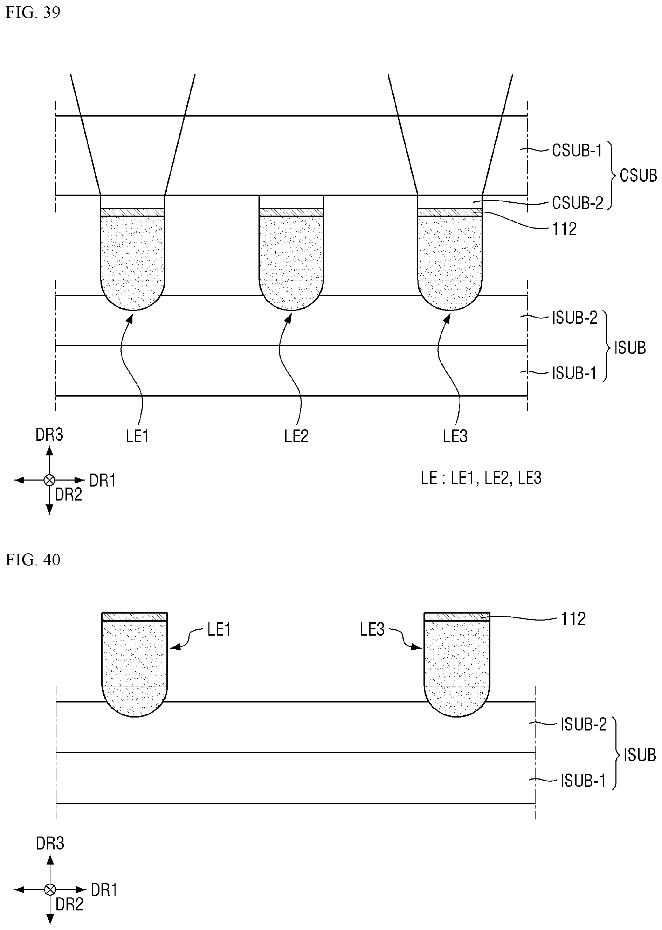

Thereafter, referring to FIGS. 39 and 40, a laser is irradiated to the corresponding light-emitting element LE to selectively transfer it to the interposer substrate ISUB, and the carrier substrate CSUB is separated.

For example, by irradiating a laser to the first light-emitting element LE1 and the third light-emitting element LE3, only the first light-emitting element LE1 and the third light-emitting element LE3 may be attached to the interposer substrate ISUB (e.g., to the exclusion of the second light-emitting element LE2). Thereafter, ultraviolet rays or heat may be applied to the carrier substrate CSUB to reduce the adhesive strength of the adhesive layer of the carrier substrate CSUB, and then the carrier substrate CSUB may be physically or naturally separated.

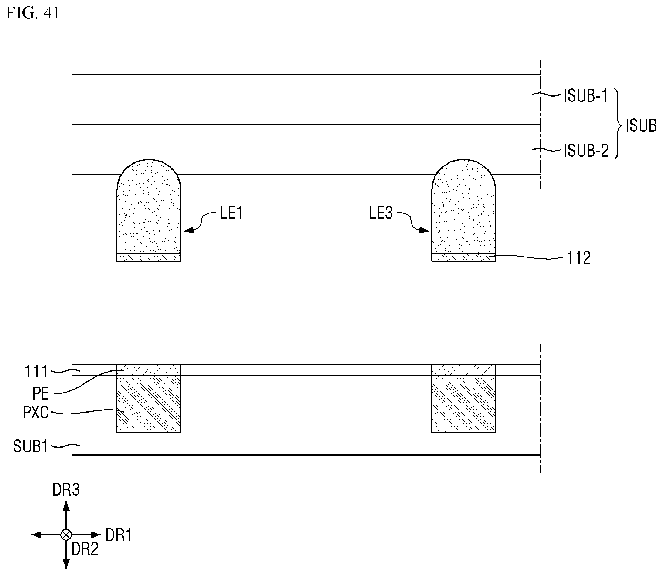

Next, referring to FIGS. 41 to 43, the light-emitting element LE attached to the interposer substrate ISUB is bonded to the first substrate SUB1, and the interposer substrate ISUB is separated.

For this purpose, the first substrate SUB1 may be prepared. The first substrate SUB1 may include a plurality of pixel circuit portions PXC and a pixel electrode PE.

For example, the pixel electrode PE is formed on the first substrate SUB1 on which the plurality of pixel circuit portions PXC are formed. Next, the interposer substrate ISUB is aligned on the first substrate SUB1. Alignment keys are placed on the first substrate SUB1 and the interposer substrate ISUB, respectively, so that alignment may be performed through these. Next, the first substrate SUB1 and the interposer substrate ISUB are bonded together.

Thereafter, the pixel electrode PE of the first substrate SUB1 is brought into contact with the connection electrode 112 of each light-emitting element LE1 and LE3. Next, each light-emitting element LE1 and LE3 is bonded to the first substrate SUB1 by melting and bonding the pixel electrodes PE and the connection electrodes 112 at a predetermined temperature.

As described with reference to FIGS. 23 to 26, an insulating layer INS, a planarization layer 113, and a common electrode CE may be formed on the first substrate SUB1. The method of forming the insulating layer INS, the planarization layer 113, and the common electrode CE has been described with reference to FIGS. 23 to 26, so redundant description will be omitted.

In another variant, as described with reference to FIGS. 27 to 30, an insulating layer INS, a planarization layer 113, a reflective layer REF, and a common electrode CE may be formed on the first substrate SUB1. The method of forming the insulating layer INS, the planarization layer 113, the reflective layer REF, and the common electrode CE has been described with reference to FIGS. 23 to 26, so redundant description will be omitted.

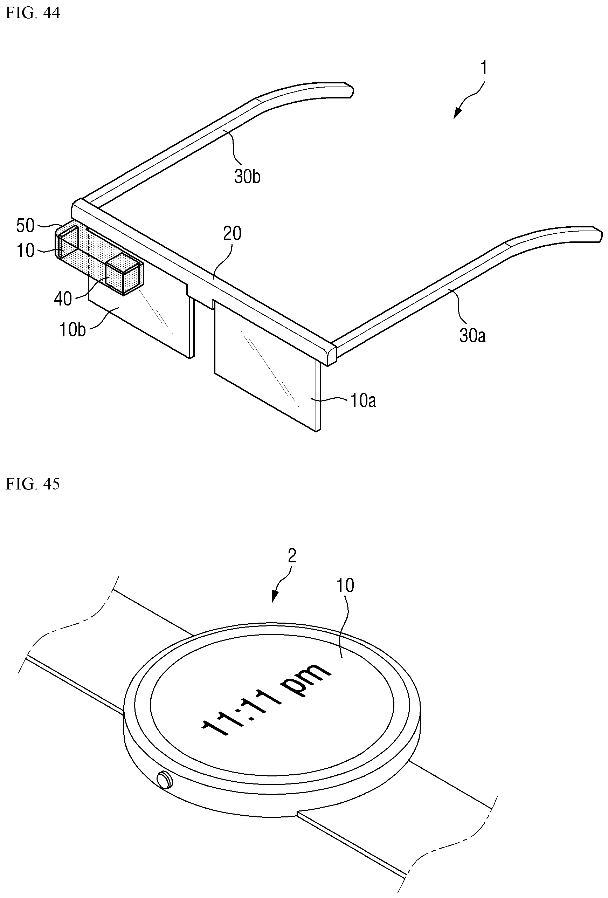

FIG. 44 is an example diagram illustrating a virtual reality device including a display device according to an embodiment. FIG. 44 illustrates a virtual reality device 1 in which the display device 10 according to an embodiment is used.

Referring to FIG. 44, the virtual reality device 1 according to an embodiment may be a device in a form of glasses. The virtual reality device 1 according to an embodiment may include a display device 10, a left-eye lens 10a, a right-eye lens 10b, a support frame 20, left and right legs 30a and 30b, a reflective member 40, and a display device housing 50.

FIG. 44 illustrates the virtual reality device 1 including the two legs 30a and 30b. However, the disclosure is not limited thereto. The virtual reality device 1 according to an embodiment may be used in a head-mounted display including a head-mounted band that may be mounted on a head instead of the legs 30a and 30b. For example, the virtual reality device 1 according to an embodiment may not be limited to the example shown in FIG. 44, and may be applied in various forms and in various electronic devices.

The display device housing 50 may receive the display device 10 and the reflective member 40. An image displayed on the display device 10 may be reflected from the reflective member 40 and provided to a user's right eye through the right-eye lens 10b. Thus, the user may view a virtual reality image displayed on the display device 10 via the right eye.

FIG. 44 illustrates that the display device housing 50 is located at a right end of the support frame 20. However, an embodiment of the disclosure is not limited thereto. For example, the display device housing 50 may be located at a left end of the support frame 20. In this case, the image displayed on the display device 10 may be reflected from the reflective member 40 and provided to the user's left eye via the left-eye lens 10a. Thus, the user may view the virtual reality image displayed on the display device 10 via the left eye. As another example, the display device housing 50 may be located at each of the left end and the right end of the support frame 20. In this case, the user may view the virtual reality image displayed on the display device 10 via both the left eye and the right eye.

FIG. 45 is a diagram illustrating a smart device including a display device according to an embodiment.

Referring to FIG. 45, a display device 10 according to an embodiment may be applied to a smart watch 2 as one of smart devices.

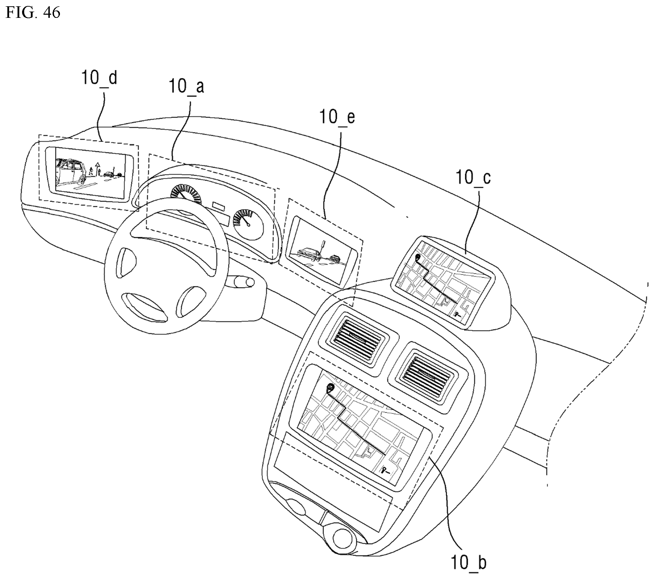

FIG. 46 is an example diagram illustrating a vehicle including a display device according to an embodiment. FIG. 46 illustrates a vehicle in which display devices according to an embodiment are used.

Referring to FIG. 46, the display devices 10_a, 10_b, and 10_c according to an embodiment may be applied to the dashboard of the vehicle, applied to the center fascia of the vehicle, or applied to a CID (Center Information Display) located on the dashboard of the vehicle. Further, each of the display devices 10_d and 10_e according to an embodiment may be applied to each room mirror display that replaces each of side-view mirrors of the vehicle.

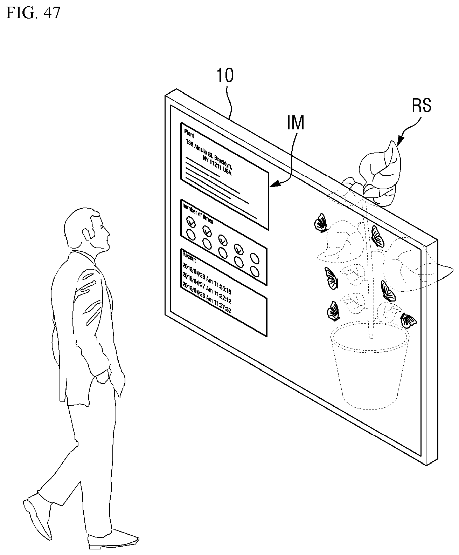

FIG. 47 is an example diagram illustrating a transparent display device including a display device according to an embodiment.

Referring to FIG. 47, a display device according to an embodiment may be applied to a transparent display device. The transparent display device may transmit light therethrough while displaying an image IM thereon. Therefore, a user located in front of the transparent display device may not only view the image IM displayed on the display device 10, but also view an object RS or a background located in rear of the transparent display device. In the case that the display device 10 is applied to the transparent display device, the first substrate 110 of the display device 10 shown in FIG. 6 may include a light-transmitting portion that may transmit light therethrough, or may be made of a material that may transmit light therethrough.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a substrate;
a light-emitting element above the substrate, and comprising a first semiconductor layer, an active layer, and a second semiconductor layer; a common electrode disposed on the light emitting element,
wherein the second semiconductor layer has a lens-shaped upper surface disposed further away from the active layer,
wherein side surfaces of the active layer and the second semiconductor layer are aligned.

2. The display device of claim 1, wherein the lens-shaped upper surface is convex downward or convex upward.

3. The display device of claim 1, wherein the second semiconductor layer comprises a lens portion having a lens-shaped upper surface contacting the common electrode, and a body portion below a lower surface of the lens portion,
wherein a side surface of the lens portion and a side surface of the body portion are aligned.

4. The display device of claim 3, further comprising a connection electrode between the substrate and the light-emitting element, and having a diameter that is greater than a diameter of the light-emitting element.

5. The display device of claim 4, wherein the diameter of the connection electrode is greater than a diameter of the lens portion.

6. The display device of claim 4, further comprising an insulating layer partially surrounding the light-emitting element.

7. The display device of claim 6, wherein the insulating layer is on a side of the light-emitting element, and on a portion of the substrate on which the light-emitting element is not located.

8. The display device of claim 6, further comprising a reflective layer on the insulating layer and partially surrounding the light-emitting element.

9. The display device of claim 3, further comprising a connection electrode between the substrate and the light-emitting element, and having a diameter that is the same as a diameter of the light-emitting element and a diameter of the lens portion.

10. The display device of claim 1, further comprising a connection electrode between the substrate and the light-emitting element; and
a pixel electrode between the substrate and the connection electrode.

11. The display device of claim 1, further comprising a convex lens-shaped micro lens above the common electrode, overlapping the light-emitting element, and convex downward.

12. The display device of claim 11, wherein a lower surface of the micro lens contacts the common electrode.

13. The display device of claim 1, wherein the second semiconductor layer has multiple downwardly convex lens shapes.

14. A method of manufacturing a display device, the method comprising:
stacking a first connection electrode layer on a second substrate on which a second semiconductor layer, an active layer, and a first semiconductor layer are sequentially grown;
bonding the second substrate and a first substrate having a pixel circuit by melting the first connection electrode layer;
removing the second substrate;
forming a lens-shaped first mask pattern on an upper surface of the second semiconductor layer;
etching the second semiconductor layer, the active layer, and the first semiconductor layer using the lens-shaped first mask pattern to form light-emitting elements having the second semiconductor layer with a lens-shaped upper surface;
forming a second mask pattern surrounding the light-emitting elements;
etching the first connection electrode layer using the second mask pattern; and
forming a common electrode on the light-emitting elements,
wherein side surfaces of the active layer and the second semiconductor layer are aligned.

15. The method of claim 14, wherein the lens-shaped upper surface is convex downward or convex upward.

16. The method of claim 14, further comprising:
stacking a second connection electrode layer on a portion of the first substrate having the pixel circuit; and
forming a connection electrode by melting and bonding the first connection electrode layer and the second connection electrode layer

17. The method of claim 14, further comprising:
depositing an insulating layer on the light-emitting element and on a portion of a first substrate on which the light-emitting element is not located;
forming a planarization layer on a portion of the first substrate on which the insulating layer is formed, the planarization layer being lower than a height of the light-emitting element; and
removing a portion of the insulating layer from a portion of the light-emitting element that is not covered by the planarization layer.

18. The method of claim 17, further comprising:
depositing a reflective material layer on a portion of the first substrate on which the insulating layer is laminated; and
removing a portion of the reflective material layer from a horizontal surface of the first substrate to form a reflective layer partially surrounding a side of the light-emitting element.

19. A method of manufacturing a display device, the method comprising:
stacking a connection electrode layer on a second substrate on which a second semiconductor layer, an active layer, and a first semiconductor layer are located;
forming light-emitting elements by etching the active layer, the first semiconductor layer, and the connection electrode layer;
bonding the second substrate having the light-emitting elements on a carrier substrate;
removing the second substrate;
forming a lens-shaped mask pattern on an upper surface of the second semiconductor layer;
etching the upper surface of the second semiconductor layer to have a lens shape using the lens-shaped mask pattern, wherein sides of the active layer and the second semiconductor layer are aligned;
transferring the light-emitting elements on the carrier substrate onto a first substrate comprising a pixel electrode using an interposer substrate;
removing the interposer substrate; and
forming a common electrode on the light-emitting elements.

20. The method of claim 19, wherein the lens shape is convex downward or convex upward.

21. The method of claim 20, wherein the carrier substrate comprises a support layer that is transparent and mechanically stable, and an adhesive layer on the support layer.

22. The method of claim 20, wherein the interposer substrate comprises a support layer that is transparent and mechanically stable, and an adhesive layer on the support layer.

23. The method of claim 20, further comprising:
depositing an insulating layer on the light-emitting element and on a portion of a first substrate on which the light-emitting element is not located;
depositing a reflective material layer on a portion of the first substrate on which the insulating layer is laminated;
forming a reflective layer surrounding a side of the light-emitting element by removing a portion of the reflective material layer above a horizontal surface of the first substrate;
forming a planarization layer on the first substrate on which the insulating layer is formed, the planarization layer being lower than a height of the light-emitting element; and
removing a portion of the insulating layer from the light-emitting element that is not covered by the planarization layer.
